Europäisches Patentamt

European Patent Office

Office européen des brevets

(19)

(11)    EP 0 890 174 B1

(12)    EUROPÄISCHE PATENTSCHRIFT

(45) Veröffentlichungstag und Bekanntmachung des
Hinweises auf die Patenterteilung:
**17.05.2000   Patentblatt 2000/20**

(21) Anmeldenummer: **97916352.4**

(22) Anmeldetag: **20.03.1997**

(51) Int Cl.⁷: $G11C\ 16/06$, G11C 8/00

(86) Internationale Anmeldenummer:
**PCT/DE97/00576**

(87) Internationale Veröffentlichungsnummer:
**WO 97/37354 (09.10.1997 Gazette 1997/43)**

(54) **HALBLEITERSPEICHERVORRICHTUNG**

SOLID-STATE MEMORY DEVICE

MEMOIRE A SEMI-CONDUCTEURS

(84) Benannte Vertragsstaaten:
**AT CH DE ES FR GB IT LI**

(30) Priorität: **28.03.1996   DE 19612456**

(43) Veröffentlichungstag der Anmeldung:
**13.01.1999   Patentblatt 1999/02**

(73) Patentinhaber: **SIEMENS
AKTIENGESELLSCHAFT
80333 München (DE)**

(72) Erfinder: **ZETTLER, Thomas
D-81737 München (DE)**

(56) Entgegenhaltungen:
EP-A- 0 182 192          US-A- 4 742 492
US-A- 4 823 318          US-A- 5 513 147

- **IEEE JOURNAL OF SOLID-STATE CIRCUITS, Bd.
27, Nr. 11, 1.November 1992, Seiten 1547-1553,
XP000320441 TOSHIKATSU JINBO ET AL: "A
5-V-ONLY 16-MB FLASH MEMORY WITH
SECTOR ERASE MODE"**

**Beschreibung**

Die Erfindung bezieht sich auf eine Halbleiterspeichervorrichtung nach dem Oberbegriff des Anspruchs 1.

Ein hauptsächliches Anwendungsgebiet einer solchen Halbleiterspeichervorrichtung sind nichtflüchtige elektrisch löschbare, programmierbare Halbleiterspeicher, die aus Speicherzellen aufgebaut sind, welche durch Anlegen vorbestimmter Spannungen beliebig oft programmiert und wieder gelöscht werden können. Die Informationsspeicherung erfolgt hierbei durch Aufbringen bzw. Entfernen von Ladungen auf der sogenannten Floating Gate Elektrode. Dies geschieht durch Anlegen von geeigneten Spannungen an Wort- und Bitleitungen der Speicheranordnung. Bei Lese-Betriebsbedingungen mit niedrigen Spannungen von typischerweise etwa 5 Volt können keine Ladungen die Isolations-Potentialbarriere überwinden, so daß die einmal gespeicherte Ladung erhalten bleibt. Beim Programmieren und Löschen werden dagegen höhere Spannungen von typischerweise etwa 17 Volt zwischen dem Steuergate und dem Source/Drain/Substrat angelegt. Diese Spannungen werden nachfolgend auch als Hochspannungen bezeichnet, da sie die Versorgungsspannung betragsmäßig übersteigen. Aufgrund einer hohen Feldstärke können Elektronen die Isolations-Potentialbarriere durchtunneln (Fowler Nordheim-Effekt) oder es können in Drain-Nähe entstandene heiße Elektronen die Isolation überwinden (Channel Hot Electron Effekt). Da die Versorgungsspannung der Speicherschaltung typischerweise etwa 5 Volt beträgt, müssen für die extern zugeführten oder intern erzeugten Programmier- und Löschspannungen Ansteuerschaltungen vorgesehen werden, welche diese Spannungen selektiv auf die Speicherzellen (bzw. Wort- und Bitleitung) schalten können. Aus schaltungstechnischen und technologischen Gesichtspunkten ist es vorteilhaft, den Spannungsbereich mindestens einer Ansteuerleitung (Bitleitung oder Wortleitung) auf kleiner oder gleich den Wert der Versorgungsspannung zu begrenzen, und nur auf der anderen Ansteuerleitung Hochspannungen einzusetzen. Als Konsequenz müssen zum Programmieren und Löschen sowohl positive als auch negative Hochspannungen selektiv auf die Leitungen geschaltet werden.

Aus Y. Yatsuda et. al., IEEE J. Solid-State Circuits, Vol. sc-20. No. 1., S. 144-151, 1985 ist eine Hochvolt-Ansteuerschaltung für positive Spannungen bekannt, welche einen externen Takt (Clock) verwendet. Die aus NMOS-Transistoren gebildete Schaltung ist jedoch nicht in der Lage, negative Hochspannungen zu schalten. Weiterhin benötigt die Schaltung eine relativ große Kapazität C, um einen ausreichend hohen Ladestrom liefern zu können, damit die Last in einer Zeit von 50 bis 100 µs aufgeladen werden kann.

Aus der EP 320 916 B1 ist eine Ansteuerschaltung für einen nichtflüchtigen elektrisch löschbaren und programmierbaren Halbleiterspeicher bekanntgeworden, welche sowohl positive als auch negative Hochspannungen schalten kann und einen externen Takt verwendet. Diese Schaltung basiert auf dem Prinzip, jeder Last einen eigenen Hochspannungsgenerator zuzuordnen, welcher die notwendige negative Hochspannung erzeugt. Die Anzahl der notwendigen Generatorstufen steigt jedoch mit dem Betrag der Hochspannung.

Bei höheren Spannungswerten erfordert dieses Konzept einen hohen Flächenbedarf. Als weiterer Nachteil liefert die bekannte Schaltung im Löschbetrieb (negative Hochspannung) im nichtselektierten Fall keinen sauberen Null-Volt-Pegel. In einer Vorbereitungsphase wird ein Precharge mit einem vorbestimmten Spannungswert auf die Last aufgebracht. Während des eigentlichen Löschvorganges wird der Pegel lediglich über die Serienschaltung eines NMOS-Transistors und mehrerer, d.h. größer gleich zwei PMOS-Transistoren begrenzt. Hierdurch ist die bekannte Schaltung auch für Störungen durch Übersprechen anfällig. Im Lesemodus (Spannung + 5 Volt) und Schreibmodus (Spannung + 15 Volt) sind die Null-Volt-Pegel ebenfalls unsauber. Die Ausgangsspannung beträgt statt dessen den Betrag einer PMOS-Einsatzspannung. Der Vorschlag, einen Transistor mit einer Einsatzspannung von null Volt einzusetzen, verlagert das Problem zu einer komplexeren und damit kostenungünstigen Technologie.

Aus IEEE JOURNAL OF SOLID-STATE CIRCUITS, Bd. 27, Nr. 11, 1. November 1992, S. 1547-1553, XP000320441, TOSHIKATSU JINBO ET AL: "A 5-V-ONLY 16-MB FLASH MEMORY WITH SECTOR ERASE MODE" ist eine Halbleiterspeichervorrichtung entsprechend dem Oberbegriff des Anspruchs 1 bekannt, bei der eine Ansteuerschaltung als Row-Main-Dekoder mit Schaltungsblöcken A und B versehen ist. Der Schaltungsblock A, welcher auch als konventioneller Block bezeichnet wird, ist einem nMOS-Depletion-Transistor für die Hochspannung nachgeschaltet und ist während des Programm-Modus aktiv. Der Spannungsblock B zum Schalten der negativen Spannung dient in erster Linie dazu, ein positiv pegeliges Signal in einen negativen Spannungspegel des Löschmodus umzuwandeln. Hierzu wird der Schaltungsblock B mit einer negativen Hochspannung von -13 Volt aus einem Ladungspumpenschaltkreis beaufschlagt und über ein Ansteuersignal ERA geschaltet. Diese vorbekannte Ansteuerschaltung ermöglicht somit die Selektion einer einzelnen Wortleitung und Ansteuerung mit einer negativen Löschspannung, nebst einer Ansteuerung mit 5 V bzw. 0 V für den Lesebetrieb. Obzwar die Funktion der vorbekannten Ansteuerschaltung mit derjenigen der erfindungsgemäßen Schaltung vergleichbar zu sein scheint, unterscheiden sich die beiden zugrunde liegenden konstruktiven Schaltungskonzepte wesentlich voneinander.

Eine weitere Ansteuerschaltung für EEPROM-Speicherzellen ist aus der US-A-4 823 318 bekannt geworden. Auch diese Ansteuerschaltung unterscheidet sich in wesentlichen konkreten Merkmalen von der erfindungsgemäßen Ansteuerschaltung.

Aus der US-A-4 742 492 ist eine weitere Ansteuerschaltung bekannt geworden, deren Zweck darin liegt, die von drei Ladungspumpen erzeugten Spannungen -Vgg, -Vpp, und +Vpp wechselweise an einen ausgangsseitigen Kondensator zu liefern. Hierzu wird in Abhängigkeit des auf einer Eingangsleitung anliegenden Steuersignals jeweils eine der drei Ladungspumpen geschaltet. Auch diese Ansteuerschaltung unterscheidet sich von der erfindungsgemäßen in den einzelnen Schaltungsdetails.

Der vorliegenden Erfindung liegt die Aufgabe zugrunde, eine Schaltungsanordnung der eingangs genannten Gattung zur Verfügung zu stellen, die schaltungstechnisch einfacher ist, eine geringere Fläche benötigt, insgesamt einen geringeren Leistungsverbrauch und möglichst keine Querströme aufweist, und dabei in allen Betriebszuständen saubere Spannungspegel, insbesondere auch glatte Null-Volt-Pegel liefert.

Diese Aufgabe wird von einer Schaltungsanordnung nach Anspruch 1 gelöst.

Erfindungsgemäß ist vorgesehen, daß zur Ansteuerung der von der Selektionssignalschaltung ausgewählten Gruppe von Speicherzellen für die Betriebszustände Löschen und Aufrechterhalten des Dateninhalts der Speicherzellen eine für alle Speicherzellen einer Gruppe gemeinsam zugeordnete Ansteuerschaltung mit einer einzigen Ansteuerleitung zur Kopplung an sämtliche Speicherzellen der ausgewählten Gruppe vorgesehen ist, auf welcher Ansteuerleitung selektiv die Löschspannung und die Referenzspannung aktiv an die ausgewählte Gruppe von Speicherzellen geschaltet ist.

Das erfindungsgemäße Schaltungskonzept löst die eingangs beschriebenen Probleme auf einfache Weise und bietet gegenüber den vorbekannten Lösungen eine Reihe von Vorteilen. Durch das Vorsehen einer allen Speicherzellen einer Gruppe gemeinsam zugeordneten Ansteuerschaltung mit einer einzigen Ansteuerleitung zum aktiven Treiben bzw. Schalten sowohl der Löschspannung (negative Hochspannung), als auch der Referenzspannung (beispielsweise mit einem genau definierten Null Volt Pegel) können die Hochspannungserzeugungsschaltungen schaltungstechnisch von der Ansteuerschaltung entkoppelt als separate Schaltungsbestandteile ausgebildet sein. Im Gegensatz zum Stand der Technik ist es nicht erforderlich, jeder Last, wobei als Last die von der Ansteuerschaltung zu treibende Leitung und zugeordnete Schaltungsbestandteile (beispielsweise Wortleitung) bezeichnet wird, einen eigenen Hochspannungsgenerator zuzuordnen, welcher die erforderliche Löschspannung (negative Hochspannung) erzeugt. Wegen der Anzahl der erforderlichen Generatorstufen, die mit dem Betrag der Hochspannung ansteigt, ist bei höheren Spannungswerten das vorbekannte Konzept flächenungünstig. Demgegenüber ermöglicht die Erfindung eine für eine Gruppe von Speicherzellen gemeinsam zugeordneten globalen Erzeugung der erforderlichen Hochspannungen, die der Ansteuerschaltung entweder von außen zugeführt oder von einer auf dem gleichen Halbleitersubstrat hergestellten Hochspannungserzeugungsschaltung zur Verfügung gestellt werden. Die Ansteuerschaltung selbst kann schaltungstechnisch einfach aufgebaut und aus nur wenigen Bauelementen zusammengestellt sein. Da die Ansteuerschaltung aus Gründen größtmöglicher Flächenersparnis in der Regel im Zellraster realisiert werden sollte, ist der Vorteil einer möglichst einfachen schaltungstechnischen Ausbildung der Ansteuerschaltung im Sinne einer hohen Integrationsdichte vorteilhaft. Gleichzeitig erfordert die Ansteuerschaltung einen lediglich geringen Leistungsverbrauch und besitzt im wesentlichen keine Querströme, die zu Leistungsverlusten beitragen könnten. Insbesondere bei der Realisierung in einer n-Wannen-CMOS-Technologie kommt diesen Vorteilen dadurch Bedeutung zu, daß sämtliche NMOS-Transistoren einen gemeinsamen Substratanschluß (Masse) besitzen, und somit zum Schalten der negativen Spannungen lediglich PMOS-Transistoren verwendet werden können.

Mit der erfindungsgemäßen Ansteuerschaltung gelingt es, selektiv, beispielsweise in Abhängigkeit eines entsprechenden Signals, sowohl die Löschspannung (negative Hochspannung), als auch die Referenzspannung (Null-Volt-Pegel) in definierter Form und verlustfrei über eine einzige Ansteuerleitung an die Speicherzellen anzulegen. Da Speicherzellen eine verhältnismäßig große kapazitive Last bilden, ist es günstig, die Spannungen aktiv durchzuschalten, was vermittels der Ansteuerschaltung gemäß Erfindung mit allenfalls geringsten zeitlichen Verzögerungen gelingt.

Zur Unterscheidung, ob eine Gruppe von Speicherzellen gelöscht oder ob deren Dateninhalte aufrechterhalten werden sollen, ist nach der Erfindung vorgesehen, daß die Ansteuerschaltung zur Selektion der auf der Ansteuerleitung geschalteten Löschspannung und Referenzspannung durch ein in einer der Ansteuerschaltung vorgeschalteten Selektionssignalschaltung erzeugtes Selektionssignal gesteuert ist. Zweckmäßigerweise ist die Selektionssignalschaltung der in den meisten Fällen einem Halbleiterspeicher ohnehin vorhandenem Addressdekoder nachgeschaltet oder in dem Halbleiterspeicher integriert ausgebildet. Dies ermöglicht es, nicht nur größere Bereiche des Halbleiterspeichers vollständig zu löschen, sondern auch innerhalb größerer Löschzyklen lediglich die Dateninhalte einzelner ausgewählter Gruppen von Speicherzellen aufrechtzuerhalten, wodurch der organisatorische Aufwand von Datenverarbeitungsprogrammen verringert werden kann. Ein weiterer Vorteil bietet sich dadurch, da die Referenzspannung betragsmäßig kleiner ist als die Löschspannung, daß die Ansteuerschaltung weniger Zeit zum Schalten der Referenzspannung benötigt als zum Schalten der Löschspannung. Durch eine gezielte Auswahl der zu löschenden Speicherzellen läßt sich die benötigte Zeit für einen Löschvorgang verkürzen.

Weiterhin ist nach der Erfindung vorgesehen, daß die Ansteuerschaltung zum aktiven Schalten der Löschspannung und der Referenzspannung auf die Ansteuerleitung ein in Abhängigkeit von einem Auswahlsignal bzw. Selektionssignal wirkende Pumpschaltung aufweist, welche die Löschspannung und die Referenzspannung wahlweise schaltet, ohne den Wert der Spannungen wesentlich zu verändern bzw. ohne diese Spannungen lokal zu erzeugen.

In Weiterführung der Erfindung kann vorgesehen sein, daß die Halbleiterspeichervorrichtung in einem dritten Betriebszustand betreibbar ist, der wahlweise dem Programmieren, Lesen und Aufrechterhalten des Dateninhalts der Speicherzellen zugeordnet ist, wobei die Halbleiterspeichervorrichtung eine über eine Schalteinrichtung mit der Ansteuerschaltung gekoppelte Programmierspannungserzeugungsschaltung zur Versorgung der Ansteuerschaltung mit einer gegenüber der Löschspannung entgegengesetztes Vorzeichen aufweisenden und den Wert der Versorgungsspannung übersteigenden Programmierspannung zum Programmieren einer Speicherzelle aufweist, und die der Ansteuerschaltung zugeordnete Schalteinrichtung zur selektiven Ausgabe der an die Ansteuerschaltung anzulegenden Programmierspannung, einer an die Ansteuerschaltung anzulegenden Lesespannung, oder der an die Ansteuerschaltung anzulegenden Referenzspannung vermittels einer Zustandsauswahlleitung an die ausgewählte Gruppe von Speicherzellen gesteuert ist. Dadurch können alle Spannungen, welche zum Programmieren, Lesen, Löschen und Aufrechterhalten des Dateninhalts von Speicherzellen erforderlich sind, über eine einzige Leitung angelegt werden.

Zum Anlegen von der Programmierspannungserzeugungsschaltung zugeführter oder betragsmäßig kleinerer Spannungen des gleichen Vorzeichens kann vorgesehen sein, daß der Schalteinrichtung eine der Programmierspannungserzeugungsschaltung nachgeschaltete Treiberschaltung vorgeschaltet ist, die an die Schalteinrichtung die dem dritten Betriebszustand zum Programmieren, Lesen und Aufrechterhalten des Dateninhalts der Speicherzellen zugeordnete Spannungspegel ausgibt. Dies ermöglicht das Anlegen prinzipiell beliebig vieler Spannungen mit einem der Löschspannung entgegengesetzten Vorzeichen. Die Stabilität dieser Spannungpegel hängt dabei weitgehend von der Qualität der Treiberschaltung ab.

Zur Kopplung der Treiberschaltung an die Ansteuerschaltung kann vorgesehen sein, daß die Ansteuerschaltung einen mit der Schalteinrichtung gekoppelten ersten Spannungseingang aufweist, an welcher im ersten und zweiten Betriebszustand die Referenzspannung, und im dritten Betriebszustand die von der Treiberschaltung ausgegebenen Spannungspegel anliegen.

Zur Kopplung der Löschspannungserzeugungsschaltung an die Ansteuerschaltung kann vorgesehen sein, daß die Ansteuerschaltung einen mit der Löschspannungserzeugungsschaltung gekoppelten zweiten Spannungseingang aufweist, an welchem im ersten und zweiten Betriebszustand die Löschspannung und im dritten Betriebszustand die Löschspannung oder eine Spannung, welche betragsmäßig kleiner oder gleich der Programmierspannung ist, anliegt.

Zum aktiven Schalten der Referenzspannung und zur Kopplung der Treiberschaltung an die Ansteuerleitung kann vorgesehen sein, daß die Ansteuerschaltung eine über einen ersten internen Takteingang zu aktivierende, zwischen dem ersten Spannungseingang und der Ansteuerleitung geschaltete erste Pumpschaltung aufweist, welche im ersten Betriebszustand zwischen dem ersten Spannungseingang und der Ansteuerleitung sperrt, im zweiten Betriebszustand als Pumpschaltung vom ersten Spannungseingang zur Ansteuerleitung arbeitet und im dritten Betriebszustand als Pumpschaltung zwischen der an den ersten Spannungseingang gekoppelten Treiberschaltung und der Ansteuerleitung arbeitet. Die erste Pumpschaltung kann wahlweise zwei verschiedene Maßnahmen durchführen. Zum einen kann vorgesehen sein, die Referenzspannung aktiv mittels eines Pumpmechanismus durchzuschalten, um ein Zusammenbrechen der Referenzspannung aufgrund von Leckströmen oder Störungen, die den Abbau einer einmal aufgebrachten Ladung bewirken, zu verhindern. Weiterhin kann vorgesehen sein, daß die erste Pumpschaltung die von der Treiberschaltung zugeführten mit einem der Löschspannung entgegengesetzten Vorzeichen aufweisenden Spannungen die Ansteuerleitung koppelt.

Zum aktiven Schalten der Löschspannung kann vorgesehen sein, daß die Ansteuerschaltung eine über einen zweiten internen Takteingang zu aktivierende, zwischen dem zweiten Spannungseingang und der Ansteuerleitung geschaltete zweite Pumpschaltung aufweist, welche im ersten Betriebszustand als Pumpschaltung vom zweiten Spannungseingang zur Ansteuerleitung arbeitet und im zweiten und dritten Betriebszustand als Sperrschaltung zwischen dem zweiten Spannungseingang und der Ansteuerleitung arbeitet. Die zweite Pumpschaltung bewirkt hierbei, die Löschspannung aktiv mittels eines Pumpmechanismus durchzuschalten, um ein Zusammenbrechen der Löschspannung aufgrund von Leckströmen oder Störungen, die den Abbau einer einmal aufgebrachten Ladung bewirken, zu verhindern, und bewirkt andererseits, bei einem aktiven Durchschalten der Referenzspannung oder bei einer Kopplung der von der Treiberschaltung zugeführten Spannungen die Löschspannung zu sperren.

Aus Gründen der Betriebssicherheit kann vorgesehen sein, daß die erste Pumpschaltung einen an einen extern ansteuerbaren Rücksetzeingang gekoppelten Rücksetzschalter aufweist, damit im ersten Betriebszustand die erste Pumpschaltung sicher als Sperrschaltung arbeitet. Es kann vorgesehen sein, bei einem von einem Adressdekoder ausgehenden Adresswechsel den Rücksetzeingang anzusteuern, damit die erste Pumpschaltung zunächst sicher sperrt.

Als weitere Maßnahme kann vorgesehen sein, daß die zweite Pumpschaltung einen über den ersten internen Takteingang ansteuerbaren Deaktivierungsschalter aufweist, damit im zweiten und dritten Betriebszustand die zweite Pumpschaltung sicher als Sperrschaltung arbeitet. Damit wird zusätzlich sichergestellt, daß bei einem aktiven Durchschalten der Referenzspannung oder bei einer Kopplung der von der Treiberschaltung zugeführten Spannungen die Löschspannung gesperrt wird.

Für die spannunungserzeugenden Schaltungen kann vorgesehen sein, daß die Halbleiterspeichervorrichtung für wenigstens eine zusammengehörende Gruppe von Speicherzellen einer Wortleitung oder Bitleitung der auf dem Halbleitersubstrat an Kreuzungsstellen von matrixförmig in Wortleitungen und Bitleitungen angeordneten Speicherzellen eine einzige Löschspannungserzeugungsschaltung und eine einzige Programmierspannungserzeugungsschaltung, die der wenigstens einen Ansteuerschaltung zugeordnet sind, aufweist. Dies ermöglicht die Verwendung global erzeugter Spannungen, welche sowohl auf dem Halbleitersubstrat erzeugt werden können, als auch extern zugeführt werden können. In beiden Fällen führt dies zu einer Flächeneinsparung gegenüber den vorbekannten Schaltungen.

Zur Aktivierung der ersten und zweiten Pumpschaltung kann vorgesehen sein, daß der Ansteuerschaltung eine Selektionsschaltung zugeordnet ist, welche in Abhängigkeit eines an einem Selektionseingang anliegenden Selektionssignals, ein an einem externen Takteingang anliegendes externes Taktsignal einem ersten oder einem zweiten internen Taktausgang zuordnet. Um die Pumpschaltungen zu aktivieren, kann ein Taktsignal vorgesehen sein, das selektiv entweder der ersten oder zweiten Pumpschaltung zugeführt wird.

Hierbei kann zur Aktivierung der ersten und zweiten Pumpschaltung beispielsweise vorgesehen sein, daß die Selektionsschaltung bei einer logischen Null am Selektionseingang das externe Taktsignal gegenphasig auf den ersten internen Taktausgang legt und den zweiten internen Taktausgang auf die logische Eins setzt und bei einer logischen Eins am Selektionseingang das externe Taktsignal gegenphasig auf den zweiten internen Taktausgang legt und den zweiten internen Taktausgang auf die logische Null setzt.

Für die Kopplung der Selektionsschaltung an die Ansteuerschaltung kann vorgesehen sein, daß im ersten und zweiten Betriebszustand der erste interne Taktausgang der Selektionsschaltung mit dem ersten internen Takteingang und der zweite interne Taktausgang der Selektionsschaltung mit dem zweiten internen Takteingang gekoppelt ist. Da im ersten und zweiten Betriebszustand jeweils eine der beiden Pumpschaltungen aktiv ist, können in diesen Betriebszuständen Taktsignale vorgesehen sein.

Zur Kopplung der Treiberschaltung über die Ansteuerschaltung an die Speicherzellen kann vorgesehen sein, daß die Schalter der ersten und zweiten Pumpschaltung und der der zweiten Pumpschaltung zugeordnete Deaktivierungsschalter jeweils MOSFET-Transistoren mit einem gemeinsamen, extern ansteuerbaren Substratanschluß aufweisen. Dadurch läßt sich das Halbleitersubstrat auf verschiedene Potentiale legen, was die Kopplung der von der Treiberschaltung geführten Spannungen, welche ein der Löschspannung entgegengesetztes Vorzeichen aufweisen, ermöglicht.

Bei einer einfachen schaltungstechnischen Realisierung der Pumpschaltung kann von Vorteil vorgesehen sein, daß dem ersten internen Takteingang ein erster Kondensator und dem zweiten internen Takteingang ein zweiter Kondensator nachgeschaltet ist.

Für die Auswahl verschiedener von der Treiberschaltung zuzuführender Spannungspegel kann vorgesehen sein, daß die Treiberschaltung in einem ersten Betriebsmodus wahlweise in Abhängigkeit eines an einem Treiberselektionseingang anliegenden Treiberselektionssignals den Spannungspegel zum Programmieren oder den zur Aufrechterhaltung des Dateninhalts ausgibt und in einem zweiten Betriebsmodus den Spannungspegel zum Lesen ausgibt. Dies erlaubt, lediglich in Abhängigkeit von Signalen, welche keine besondere elektrische Leistung aufweisen müssen, an eine einzige Ansteuerleitung Spannungen verschiedener Vorzeichen anzulegen, wobei die Spannungen beider Vorzeichen die Versorgungsspannung überschreiten können.

In weiterführender Ausgestaltung kann vorgesehen sein, daß am gemeinsamen, extern ansteuerbaren Substratanschluß im ersten und zweiten Betriebszustand die Referenzspannung, im dritten Betriebszustand und ersten Betriebsmodus die Programmierspannung und im dritten Betriebszustand und zweiten Betriebsmodus die Lesespannung anliegt.

Um schelle Schaltzeiten zu ermöglichen, kann vorgesehen sein, daß im dritten Betriebszustand am ersten internen Takteingang unmittelbar nach dem Umschalten in den dritten Betriebszustand ein Taktsignal mit einer vorbestimmten zeitlichen Länge anliegt. Im dritten Betriebszustand ist es ausreichend, das Taktsignal nur in der Anfangsphase anzulegen und es danach auf dem Pegel, welcher den Pumpschalter der ersten Pumpschaltung offen hält, anzuhalten.

Bei einer weiterhin bevorzugten Ausführung kann vorgesehen sein, daß die Selektionsschaltung einen zweiten externen Takteingang zum Anlegen eines vom externen Taktsignal getrennten zweiten externen Taktsignals und eine dem zweiten internen Taktausgang und den beiden Takteingängen zugeordnete Amplitudenverdopplerschaltung aufweist, welcher bei einer logischen Null am Selektionseingang das externe Taktsignal gegenphasig auf den ersten internen Taktausgang legt und den zweiten internen Taktausgang auf die logische Eins setzt, und bei einer logischen Eins am Selektionseingang das externe Taktsignal gegenphasig mit einer gegenüber dem externen Taktsignal erhöhten Amplitude, auf den zweiten internen Taktausgang legt und den ersten internen Taktausgang auf die logische Null setzt. Bei einer weiteren Ausführung insbesondere der zweiten Pumpschaltung kann vorgesehen sein, Taktsignale anzulegen, welche die Versorgungsspannung übersteigen, um die Schalter des Pumpschaltkreises sicher anzusteuern.

Unter Berücksichtigung der verwendeten Technologie und des physikalischen Aufbaus der Speicherzellen kann vorgesehen sein, daß die Referenzspannung einen Nullspannungswert, die Versorgungsspannung einen Wert von etwa + 5 Volt, die Löschspannung einen Wert von etwa - 12 Volt, und die Programmierspannung einen Wert von etwa + 18 Volt besitzt.

Weitere Merkmale, Vorteile und Zweckmäßigkeiten der Erfindung ergeben sich aus der nachfolgenden Beschreibung von Ausführungsbeispielen anhand der Zeichnung. Es zeigt:

Figur 1 A und 1 B    den schematischen Aufbau einer Speicherzelle eines nichtflüchtigen elektrisch löschbaren, programmierbaren Halbleiterspeichers;

Figur 2    die Anordnung der Speicherzellen und deren Kopplung an die Bit- und Wortleitungen;

Figur 3    ein schematisches Schaltbild eines ersten Ausführungsbeispieles einer Ansteuerschaltung mit einer Selektionsschaltung mit Amplitudenverdoppler;

Figur 4    ein schematisches Schaltbild einer Treiberschaltung für positive Spannungen;

Figur 5    eine schematische Darstellung eines Simulationsergebnisses mit den am Selektionseingang und an der Ansteuerleitung anliegenden Spannungen als Funktionen der Zeit nach Anlegen einer Löschspannung und der Referenzspannung an eine Wortleitung;

Figur 6    eine schematische Darstellung eines Simulationsergebnisses mit den am Selektionseingang, an der Ansteuerleitung, am zweiten internen Takteingang und am Steuereingang des Pumpschalttransistors der zweiten Pumpschaltung anliegenden Spannungen als Funktionen der Zeit nach Anlegen einer Löschspannung und der Referenzspannung an eine Wortleitung;

Figur 7    eine schematische Darstellung eines Simulationsergebnisses mit den am Selektionseingang, am Ausgang der Treiberschaltung, und an der Ansteuerleitung anliegenden Spannungen als Funktionen der Zeit nach Anlegen einer Programmierspannung und der Referenzspannung an eine Wortleitung;

Figur 8    eine schematische Darstellung eines Simulationsergebnisses mit den am Selektionseingang, am Ausgang der Treiberschaltung, und an der Ansteuerleitung anliegenden Spannungen als Funktionen der Zeit beim Anlegen einer Lesespannung und der Referenzspannung an eine Wortleitung;

Figur 9    ein schematisches Schaltbild eines zweiten Ausführungsbeispieles einer Ansteuerschaltung mit einer Selektionsschaltung ohne Amplitudenverdoppler; und

Figur 10    ein schematisches Schaltbild eines dritten Ausführungsbeispieles einer Ansteuerschaltung mit einer Selektionsschaltung ohne Amplitudenverdoppler.

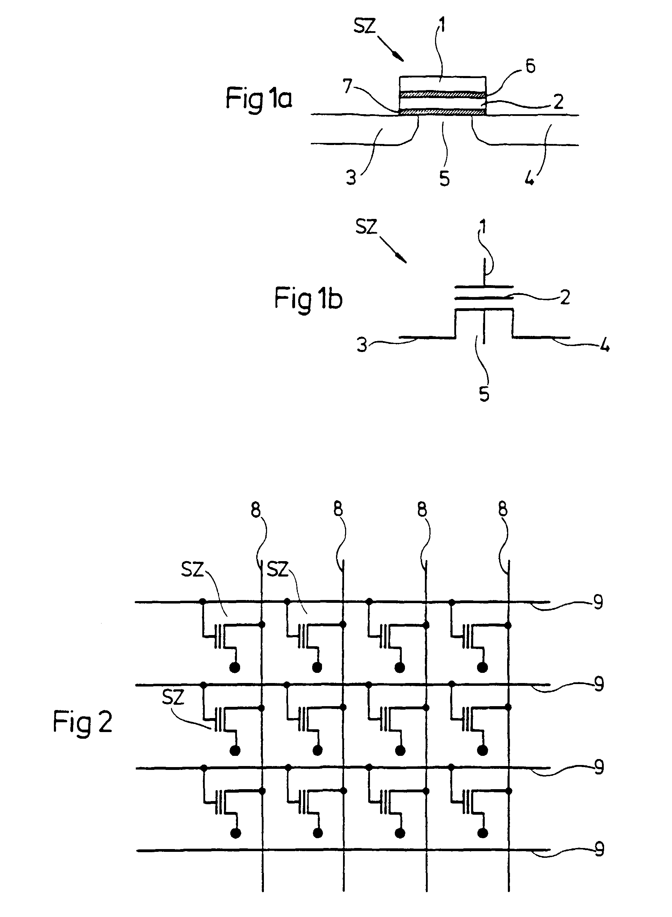

Anhand der Figuren 1A und 1B soll zunächst der Aufbau und die Wirkungsweise eines elektrisch programmierbaren und löschbaren Halbleiterspeichers mit einer Vielzahl von Speicherzellen SZ erläutert werden. Jede Speicherzelle SZ besteht aus einer Steuerelektrode 1, einer potentialungebundene Elektrode 2, einem Sourcebereich 3, einem Drainbereich 4, einem Substratbereich 5 und Isolatoren 6 und 7. Der Isolator 6 ist zwischen der Steuerelektrode 1 und der potentialungebundenen Elektrode 2, der Isolator 7 ist zwischen der potentialungebundenen Elektrode 2 einerseits und dem Sourcebereich 3, dem Drainbereich 4 und dem Substratbereich 5 andererseits angeordnet. Die potentialungebundene Elektrode 2 befindet sich, von den Isolatoren 6 und 7 umgeben, zwischen der Steuerelektrode 1, dem Sourcebereich 3 und dem Drainbereich 4. Die Speicherung von Informationen entspricht dem Aufbringen und Entfernen von Ladungen auf der potentialungebundenen Elektrode 2. Dies geschieht durch Anlegen geeigneter Spannungen zwischen der Steuerelektrode 1 und dem Drainbereich 4. Zum Lesen wird an die Steuerelektrode 1 einen positive Spannung, welche typischerweise etwa + 2,5 Volt beträgt und damit in der Größenordnung der Versorgungsspannung liegt, und welche nicht ausreicht, damit Elektronen oder Löcher den Isolatior überwinden können, an den Drainbereich 4 angelegt. Zum Programmieren wird eine positive Hochspannung, welche typischerweise etwa + 18 Volt beträgt und damit die Versorgungsspannung übersteigt, an die Steuerelektrode 1 angelegt, um Elektronen in die potentialungebundene Elektrode 2 zu injizieren. Zum Löschen wird eine negative Hochspannung, welche typischerweise etwa - 12 Volt beträgt und damit die Versorgungsspannung betragsmäßig übersteigt, an die Steuerelektrode 1 angelegt, um Löcher in die potentialunabhängige Elektrode 2 zu injizieren. Beim Programmieren und Löschen können aufgrund der hohen Feldstärke Elektronen bzw. Löcher die Potentialbarriere des Isolators 7 durchtunneln (Fowler-Nordheim-Effekt), oder es können in der Nähe des Drainbereiches 4 entstandene heiße Elektronen den Isolator 7 überwinden ("channel hot electron effect").

In einer typischen Speicheranordnung gemäß Figur 2 wird beim Auslesen der gespeicherten Dateninhalte aus den Speicherzellen SZ eine Bitleitung 8 an den Sourceanschluß der Zellen durchgeschaltet oder bleibt abgetrennt. Es sind den Bitleitungen 8 zugeordnete (nicht näher dargestellte) Leseverstärker vorgesehen, welche den Zellzustand durch den Nachweis des durch die Speicherzelle SZ fließenden Stromes oder durch den Nachweis einer Potentialverschiebung auf der jeweiligen Bitleitung 8 detektieren. Die Bezugsziffern 9 bezeichnen Wortleitungen, die zur Adressierung der Speicherzellen SZ mit einer (nicht näher dargestellten) Adressdekoderschaltung verbunden sind. Einzelheiten der Anordnung und Funktionsweise eines solchen Speichers sind dem Fachmann geläufig und sollen daher hier nicht näher beschrieben werden.

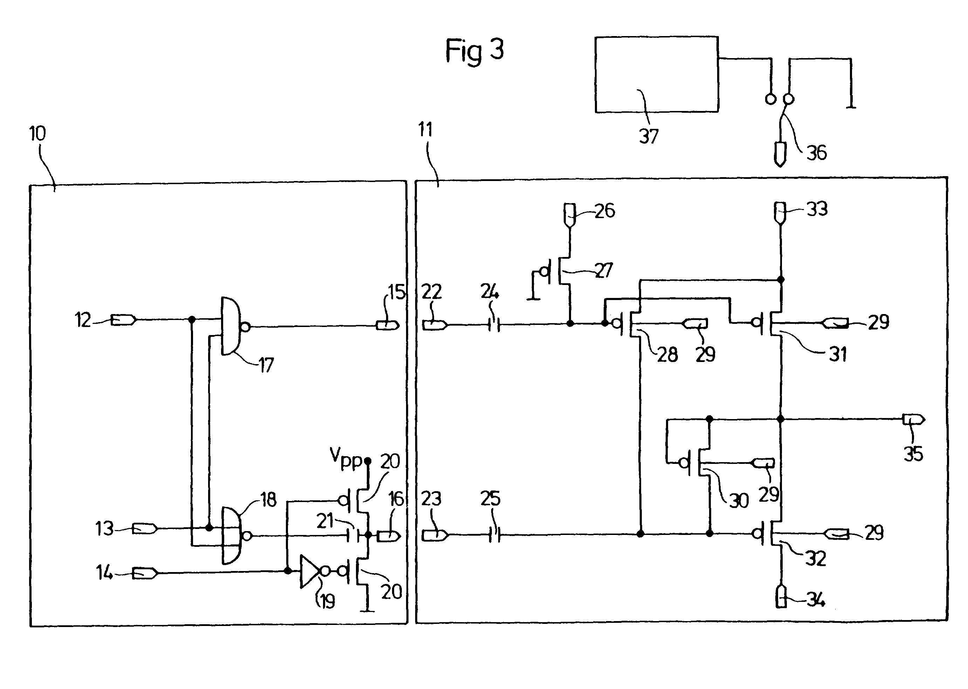

Figur 3 zeigt ein erstes Ausführungsbeispiel der erfindungsgemäßen Schaltungsanordnung mit einer Selektionsschaltung 10 und einer Ansteuerschaltung 11. Die Selektionsschaltung 10 weist einen Selektionseingang 12, einen ersten externen Takteingang 13, einen zweiten externen Takteingang 14, einen ersten internen Taktausgang 15 und einen zweiten internen Taktausgang 16 auf. Weiterhin besteht die Selektionsschaltung 10 aus einem negierten UND-Gatter 17 und einem negierten ODER-Gatter 18. Die jeweils ersten Eingänge der beiden Gatter 17 und 18 sind mit dem Selektionseingang 12 gekoppelt, und die jeweils zweiten Eingänge der beiden Gatter 17 und 18 sind mit dem ersten externen Takteingang 13 gekoppelt. Der Ausgang des negierten UND-Gatters 17 entspricht dem ersten internen Taktausgang 15 der Selektionsschaltung 10. Der Ausgang des negierten ODER-Gatters 18 ist über den Kondensator 21 mit dem zweiten internen Taktausgang 16 der Selektionsschaltung 10 verbunden. Ebenfalls am zweiten internen Taktausgang 16 liegt der Koppelpunkt zweier in Reihe geschalteter Transistoren 20. An der aus den beiden Transistoren 20 bestehenden Reihenschaltung liegt die Versorgungsspannung $V_{pp}$ an. Der Steuereingang eines der Transistoren 20 ist direkt mit dem Takteingang 14 verbunden, während der Steuereingang des anderen der beiden Transistoren 20 über ein NICHT-Gatter 19 mit dem zweiten externen Takteingang 14 verbunden ist. An den Steuereingängen der beiden Transistoren 20 liegen dadurch stets zueinander inverse digitale Signale an. Die Bauelemente 19 bis 21 bilden eine Amplitudenverdopplerschaltung. Die Ansteuerschaltung 11 besitzt fünf Eingänge 22, 23, 26, 33, 34 und einen einzigen Ausgang 35. Die Eingänge 22 und 23 stellen mit den internen Taktausgängen 15, 16 der Selektionsschaltung 10 gekoppelte interne Takteingänge der Ansteuerschaltung 11 dar. Der Eingang 26 ist ein extern ansteuerbarer Rücksetzeingang. Der erste Spannungseingang 33 ist in Abhängigkeit einer Schalteinrichtung 36 entweder im ersten und zweiten Betriebszustand an Masse, welche in allen Ausführungsbeispielen das Potential der Referenzspannung darstellt, oder im dritten Betriebszustand an eine positive Spannungen zuführende Treiberschaltung 37 gekoppelt. Der zweite Spannungseingang 34 ist an eine die negative Hochspannung erzeugende Löschspannungserzeugungsschaltung gekoppelt. Über die Ansteuerleitung 35 und die entsprechende Wortleitung 9 (siehe Figur 2) werden die Steuerelektroden 1 der Speicherzellen SZ angesteuert. Der erste interne Takteingang 22 ist über den Kondensator 24 mit dem Steuereingang eines als Pumpschalter arbeitenden Transistors 31 verbunden. Zwischen dem Steuereingang des Transistors 31 und dem Rücksetzeingang 26 ist der als Rücksetzschalter arbeitende Transistor 27 zwischengeschaltet, dessen Steuereingang auf Masse liegt. Der zweite interne Takteingang 23 ist über den Kondensator 25 mit dem Steuereingang eines als Pumpschalter arbeitenden Transistors 32 verbunden. Zwischen dem ersten Spannungseingang 33 und dem Steuereingang des Transistors 31 ist ein als Deaktivierungsschalter arbeitender Transistor 28, welcher mit dem Transistor 31 den Steuereingang gemeinsam hat, geschaltet. Zwischen der Ansteuerleitung 35 und dem Steuereingang des Transistors 32 ist ein als Rückkoppelschalter arbeitender Transistor 30 geschaltet, dessen Steuereingang ebenfalls an die Ansteuerleitung 35 gekoppelt ist. Die Transistoren 28, 30, 31 und 32 besitzen einen gemeinsamen, extern ansteuerbaren Substratanschluß 29. In allen Ausführungsbeispielen ist vorgesehen, daß am ersten Spannungseingang 33 im dritten Betriebszustand die von der Treiberschaltung 37 zugeführte positive Spannung und im ersten und zweiten Betriebszustand der Null-Volt-Pegel angelegt wird. Ebenso ist in allen Ausführungsbeispielen vorgesehen, daß an den Eingang 34 im ersten und zweiten Betriebszustand die von der Löschspannungserzeugungsschaltung zugeführte negative Hochspannung angelegt wird, und im dritten Betriebszustand entweder die von der Löschspannungserzeugungsschaltung zugeführte negative Hochspannung oder eine Spannung, welche betragsmäßig kleiner oder gleich der Programmierspannung ist, angelegt wird. Diese Spannungen werden entweder von externen oder sich auf dem Halbleitersubstrat 5 befindenden Spannungserzeugungsschaltungen zugeführt, welche in den Figuren nicht näher dargestellt sind. Dabei sind im Prinzip nur zwei spannungserzeugende Schaltungen erforderlich, eine für die positive Spannung zum Lesen und die positive Hochspannung zum Programmieren und eine weitere für die negative Hochspannung zum Löschen.

Anhand des in der Figur 3 dargestellten ersten Ausführungsbeispieles wird im folgenden die Funktionsweise erläutert. Die Ansteuerschaltung 11 arbeitet in den drei genannten Betriebszuständen. Im ersten und zweiten Betriebszustand wird der erste Spannungseingang 33 durch die Schalteinrichtung 36 an die Masse geschaltet. Ist am Selektionseingang 12 ein dem ersten Betriebszustand entsprechendes Signal angelegt, wird über die Ansteuerleitung 35 und der den entsprechenden Speicherzellen SZ zugeordneten Wortleitung 9 an die Steuerelektroden 1 die an zweiten Spannungseingang 34 anliegende negative Hochspannung von etwa - 12 Volt angelegt, um zum Löschen Löcher in die potentialunabhängigen Elektroden 2 der Speicherzellen SZ zu injizieren. Liegt am Selektionseingang 12 ein dem zweiten Betriebszustand entsprechendes Signal an, wird über die Ansteuerleitung 35 und der den entsprechenden Speicherzellen SZ zugeordneten Wortleitung 9 das am ersten Spannungseingang 33 anliegende Massepotential auf die Steuerelektroden 1 der entsprechenden Speicherzellen SZ durchgeschaltet. Im dritten Betriebszustand werden die am ersten Spannungseingang 33 anliegenden, von der Treiberschaltung 37 über die Schalteinrichtung 36 zugeführten positiven Spannungen auf die Ansteuerleitung 35 durchgeschaltet. Im ersten Betriebszustand liegt am Selektionseingang 12 die Nullspannung an, wodurch das am ersten externen Takteingang 13 anliegende Taktsignal mit doppelter Amplitude $U_{23,\,max}$ auf den zweiten internen Taktausgang 16 und damit auf den zweiten internen Takteingang 23 durchgeschaltet wird. Die aus dem NICHT-Gatter 19, den beiden Transistoren, 20 und dem Kondensator 21 aufgebaute Amplitudenverdopplerschaltung ist zum sicheren Ansteuern des Transistors 32 erforderlich. Am zweiten internen Takteingang 23 wird dazu ein Taktsignal $U_{23}$ mit einer Amplitude $U_{23,\,max}$ benötigt, welche die Einsatzspannung $U_{32,\,min}$ des Transisitors 32 um das Dopplelte überschreitet. Zur Versorgung der Amplitudenverdopplerschaltung 19, 20 ,21 liegen an den beiden externen Takteingängen 13, 14 zwei getrennte Taktsignale mit einem oberen Spannungspegel von 5 Volt und einem unteren Spannungspegel von 0 Volt an. Durch das am zweiten internen Takteingang 23 anliegende Taktsignal $U_{23}$ wird die aus dem Kondensator 25 und dem Transistor 32 bestehende zweite Pumpschaltung aktiviert und schaltet die am zweiten Spannungseingang 34 anliegende negative Hochspannung paketweise durch. Die am Steuereingang des Transistors 32 anliegende Spannung $U_{32}$ setzt sich anfangs aus der an der Ansteuerleitung 35 anliegenden Spannung $U_{35}$ und dem Betrag der Einsatzspannung $U_{32,\,min}$ des Transistors 32

$$U_{32} = U_{35} + \left| U_{32,\,min} \right|$$

zusammen und wird beim Einsatz des Taktsignals $U_{23}$ mit der Amplitude $U_{23,\,max}$ am zweiten internen Takteingang 23 um die Differenz

$$dU = U_{23,\,max} - 2 * \left| U_{32,\,min} \right|$$

zwischen der am zweiten internen Takteingang 23 anliegenden Taktamplitude $U_{23,\,max}$ und dem Doppelten des Betrages der Einsatzspannung $U_{32,\,min}$ des Transistors 32 vermindert:

$$U_{35} \rightarrow U_{35} - dU.$$

Die obigen Gleichungen gelten allerdings nur, wenn die Kapazität $C_{25}$ des Kondensators 25 groß gegen die parasitären Kapazitäten und Kapazitäten $C_{30}$, $C_{32}$ der Transistoren 30 und 32 ist. Der erste interne Taktausgang 15 und damit auch der erste interne Takteingang 22 sind deaktiviert, was bewirkt, daß der Pumpschalter 31 der ersten Pumpschaltung zwischen dem ersten Spannungseingang 33 und der Ansteuerleitung 35 sperrt. Der Rücksetzeingang 26 liegt außer bei einem Adresswechsel ständig auf Masse. Bei einem Adresswechsel wird am Rücksetzeingang 26 kurzzeitig die Versorgungsspannung angelegt, um die Steuereingänge der Transistoren 28 und 31 auf ein nicht negatives Potential zu setzen. Die Steuereingänge der Transistoren 28 und 31 könnten sonst durch Überkopplung auf ein negatives Potential gelangen, wodurch die Transistoren 28 und 31 dauerhaft geöffnet werden könnten. Im zweiten Betriebszustand liegt am Selektionseingang 12 ein Fünf-Volt-Pegel an, wodurch das am ersten externen Takteingang 13 anliegende Taktsignal invers auf den ersten internen Taktausgang 15 und damit auf den ersten internen Takteingang 22 durchgeschaltet wird. Durch das Taktsignal wird die aus dem Kondensator 24 und dem Transistor 31 bestehende erste Pumpschaltung aktiviert und schaltet die am ersten Spannungseingang 33 anliegende Nullspannung aktiv durch. Dagegen ist der zweite interne Taktausgang 16 und damit auch der zweite interne Takteingang 23 deaktiviert, wodurch der Pumpschalter 32 der zweiten Pumpschaltung zwischen dem zweiten Spannungseingang 34 und der Ansteuerleitung 35 sperrt. Im dritten Betriebszustand liegt ebenfalls am Selektionseingang 12 ein Fünf-Volt-Pegel an, wodurch das am ersten externen Takteingang 13 anliegende Taktsignal zum ersten internen Takteingang 22 durchgeschaltet wird. Durch das Taktsignal wird die aus dem Kondensator 24 und dem Transistor 31 bestehende erste Pumpschaltung aktiviert und schaltet die am ersten Spannungseingang 33 anliegende, von der Treiberschaltung 37 über die Schalteinrichtung 36 zugeführte, positive Spannung aktiv durch. In Abhängigkeit der an den beiden Treiberselektionseingängen 43, 44 anliegenden Signale werden von der Treiberschaltung 37 die Programmierspannung, die Lesespannung oder die Nullspannung am ersten Spannungseingang 33 angelegt. Ebenso werden im dritten Betriebszustand an den extern ansteuerbaren Substratanschlüssen 29 von der Treiberschaltung 37 die gleichen Spannungen angelegt wie am ersten Spannungseingang 33. Um schnelle Schaltzeiten zu ermöglichen, kann es sinnvoll sein, den Takt nur in der Anfangsphase einzuschalten und ihn dann auf dem niedrigeren Pegel anzuhalten. Dadurch bleibt der Steuereingang des Transistors 31 auf einem negativen Potential, wodurch der Tranistor 31 offen bleibt. Der zweite interne Taktausgang 16 und damit auch der zweite interne Takteingang 23 sind deaktiviert, wodurch der Pumpschalter 32 der zweiten Pumpschaltung zwischen dem zweiten Spannungseingang 34 und der Ansteuerleitung 35 sperrt.

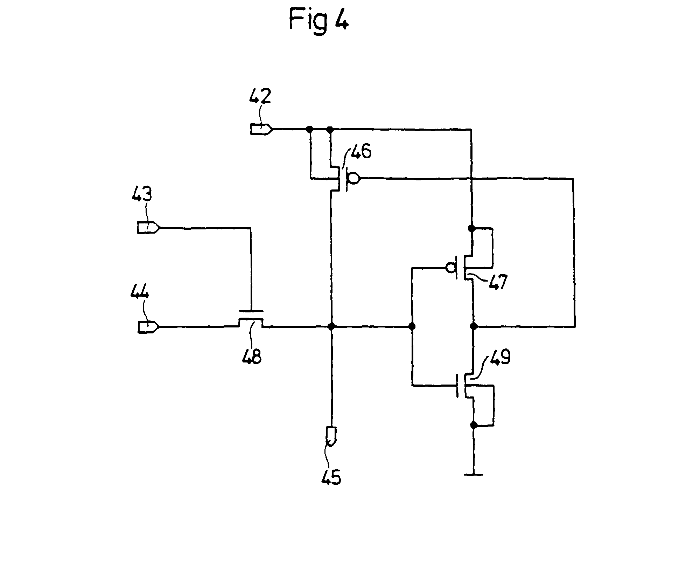

Figur 4 zeigt nähere Einzelheiten der Treiberschaltung 37, welche einer Programmierspannungserzeugungsschaltung nachgeschaltet ist, über die Schalteinrichtung 36 mit der Ansteuerschaltung 11, 39, 40 gekoppelt ist und die Zuführung der positiven Spannungen zur Ansteuerschaltung 11, 39, 40 bewirkt. Die Schaltung 37 weist drei Eingänge 42, 43, 44 und einen Ausgang 45 auf. Der Ausgang 45 ist zur Kopplung über die Schalteinrichtung 36 an den ersten Spannungseingang 33 der Ansteuerschaltung 11 vorgesehen. Die Treiberschaltung 37 besteht aus vier Transistoren, zwei p-Kanal-FET-Transistoren 46, 47 und zwei n-Kanal-FET-Transistoren 48, 49. Der Eingang 42 ist ein Spannungseingang zur Kopplung einer Programmierspannungserzeugungsschaltung bzw. zum Anlegen einer positiven Hochspannung, welche typischerweise etwa + 18 Volt beträgt. Die Eingänge 43 und 44 sind Treiberselektionseingänge. In Abhängigkeit der an den Treiberselektionseingängen 43, 44 anliegenden Signale schaltet die Treiberschaltung entweder die am Eingang 42 anliegende positive Hochspannung zum Programmieren oder schaltet eine typischerweise etwa + 2,5 Volt hohe Teilspannung zum Lesen, oder schaltet einen Null-Volt-Pegel zum Aufrechterhalten des Dateninhalts auf den Ausgang 45 und damit auf den ersten Spannungseingang 33 der Ansteuerschaltung 11, 39, 40 durch.

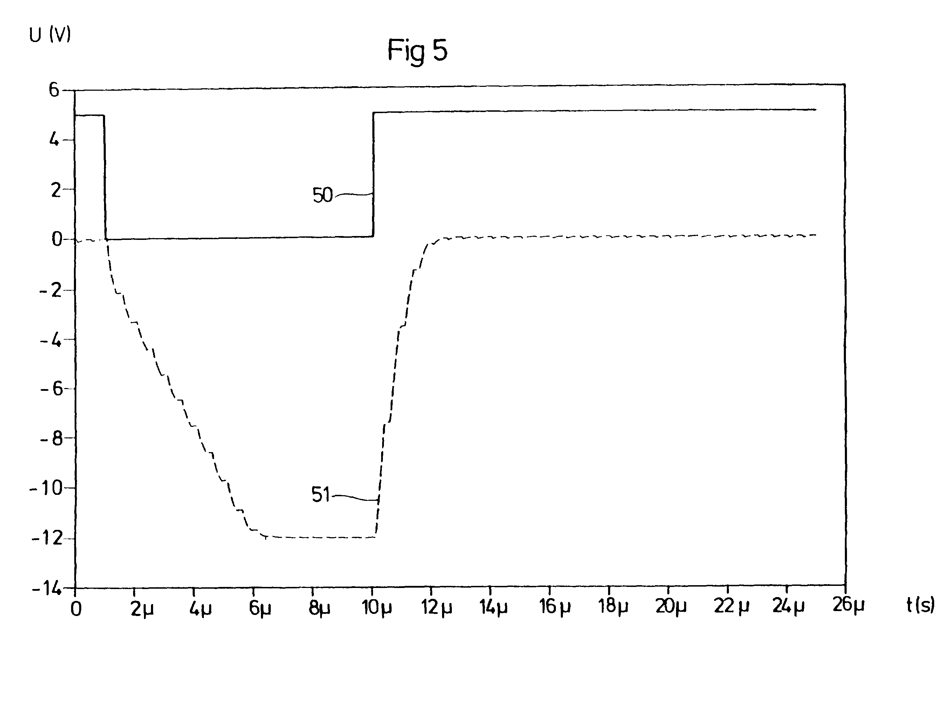

In den Figuren 5 bis 8 ist der zeitliche Verlauf der an verschiedenen ausgewählten Punkten der in Figur 3 dargestellten Schaltung anliegenden Spannungen dargestellt.

Figur 5 zeigt den zeitlichen Spannungsverlauf des am Selektionseingang 12 anliegenden Signals 50 und des an der Ansteuerleitung 35 anliegenden Signals 51. Durch Ansteuern des Selektionseinganges 12 wird zwischen dem ersten und zweiten Betriebszustand geschalten. Der Null-Volt-Pegel am Selektionseingang 12 entspricht dem ersten und der Fünf-Volt-Pegel dem zweiten Betriebszustand. Liegt am Selektionseingang 12 der Fünf-Volt-Pegel an, wird auf die Ansteuerleitung 35 der am ersten Spannungseingang 33, welcher über die Schalteinrichtung 36 an die Masse gekoppelt ist, anliegende Null-Volt-Pegel durchgeschaltet. Bei einem Null-Volt-Pegel am Selektionseingang 12 wird die am zweiten Spannungseingang 34 anliegende Löschspannung, welche hier etwa -12 Volt beträgt, auf die Ansteuerleitung durchgeschaltet. Der Pumpvorgang dauert etwa 5 µs, bis die vorbestimmte Spannung erreicht ist. Nach einem Umschalten am Selektionseingang dauert es dagegen nur etwa 2 µs, bis die Referenzspannung an der Ansteuerleitung anliegt.

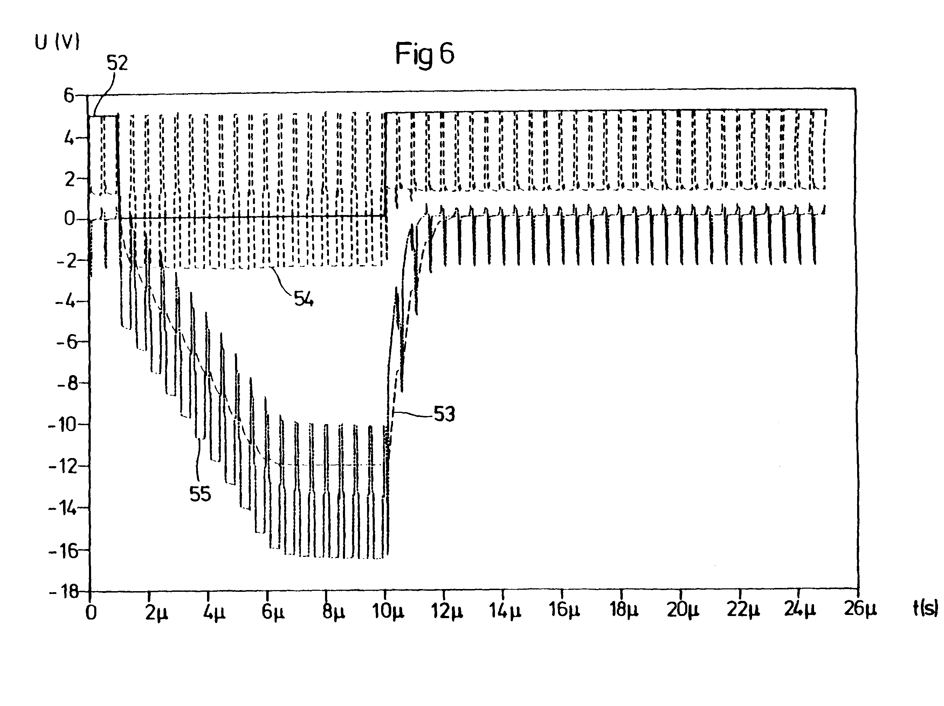

Die in Figur 6 dargestellten Spannungsverläufe 52, 53, 54, 55 geben den gleichen Vorgang wie in Figur 5 wieder. Die in Figur 6 dargestellten Diagramme 52 und 53 entsprechen den Diagrammen 50 bzw. 51 aus der Figur 5. Zusätzlich ist in Figur 6 der Verlauf der Spannung 54 am zweiten internen Takteingang 23 und der Verlauf der Spannung 55 am Steuereingang des zweiten Pumpschalters 32 dargestellt. An beiden Punkten oszilliert die Spannung mit der Frequenz des Taktsignals. Beim ersten Betriebszustand beträgt die Amplitude beider Signale 54, 55 etwa 7 Volt, während im zweiten Betriebszustand die Amplitude beider Signale etwa 4 Volt beträgt. Das am Steuereingang des zweiten Pumpschalters 32 anliegende Signal 55 entspricht dem an der Ansteuerleitung 35 anliegenden, mit dem Signal 54 am zweiten Takteingang 23 amplitudenmodulierten Signal 53.

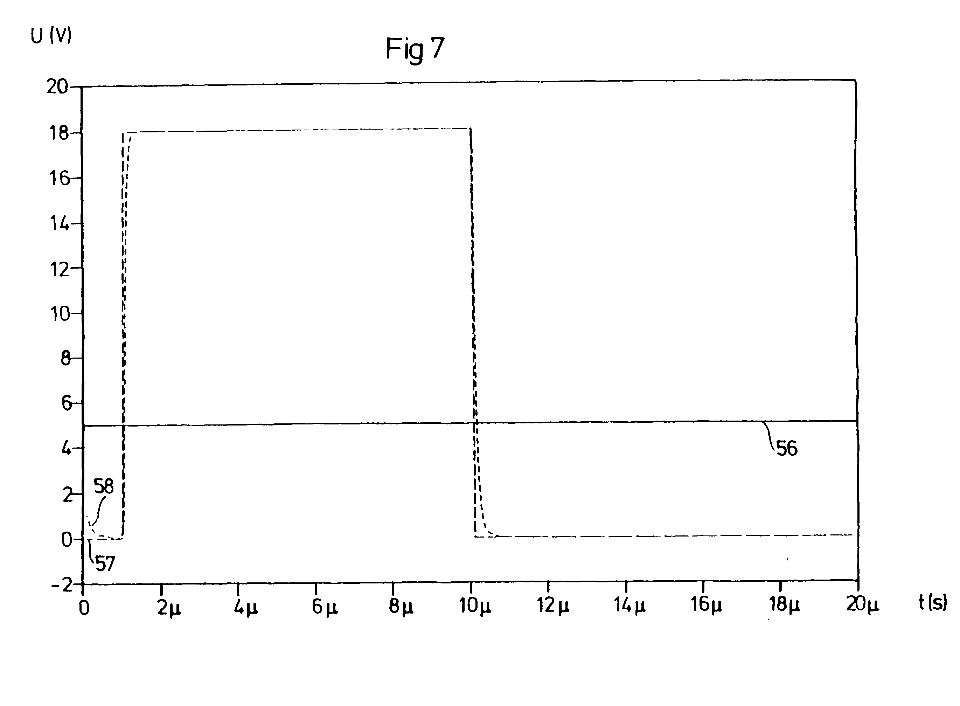

In Figur 7 sind Diagramme 56, 57, 58 dargestellt, welche den Spannungsverlauf 56 am Selektionseingang 12, den Spannungsverlauf 57 am ersten Spannungseingang 33 und den Spannungsverlauf 58 an der Ansteuerleitung 38 in der dritten Betriebsart darstellen. Der Selektionseingang 12 liegt permanent auf 5 Volt, da die dort anliegenden Signale 56 nur für die ersten beiden Betriebsarten relevant sind. Ein Vergleich des Spannungsverlaufs 57 am ersten Spannungseingang 33 und des Spannungsverlaufs 58 an der Ansteuerleitung 35 zeigt, daß die Ansteuerschaltung 11 die von der Treiberschaltung 37 zugeführte positive Hochspannung nahezu ohne Verzögerung durchschaltet. Die Verzögerungszeit beträgt weniger als etwa 1 µs.

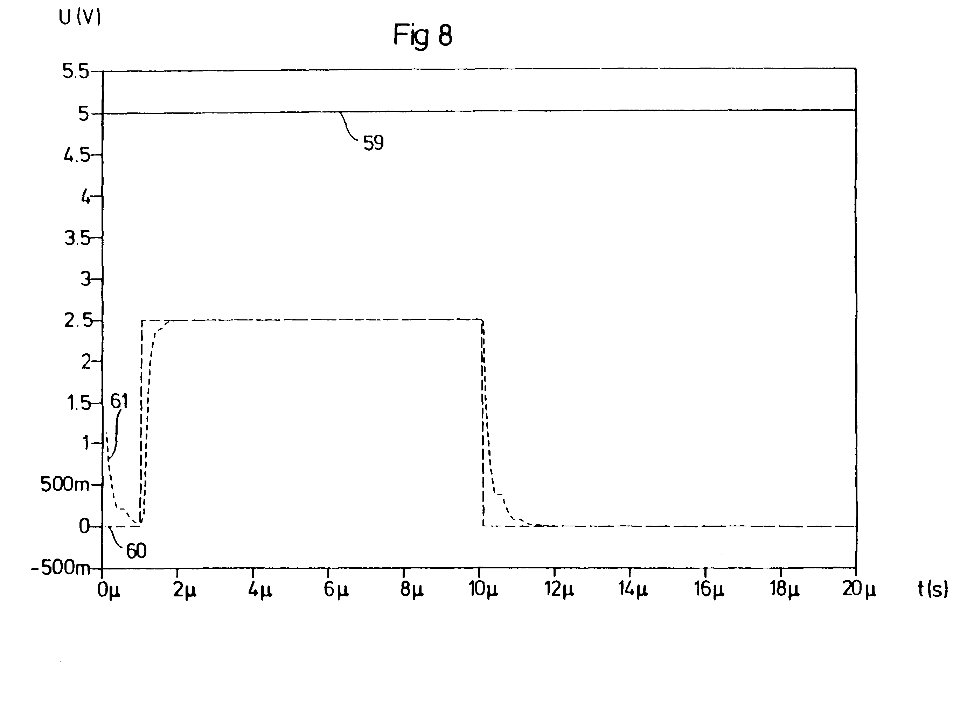

In Figur 8 ist analog zur Figur 7 das Durchschalten einer von der Treiberschaltung 37 zugeführten positiven Spannung dargestellt, wobei der Spannungsverlauf 59 am Selektionseingang 12, der Spannungsverlauf 60 am ersten Spannungseingang 33 und der Spannungsverlauf 61 an der Ansteuerleitung 38 im dritten Betriebszustand dargestellt ist. Anstelle der Programmierspannung, welche etwa + 18 Volt beträgt, wird die Lesespannung von etwa + 2,5 Volt angelegt. Auch in diesem Fall befinden sich die Verzögerungszeiten etwa in der gleichen Größenordnung wie beim Anlegen der Programmierspannung und liegen unter etwa 1 µs.

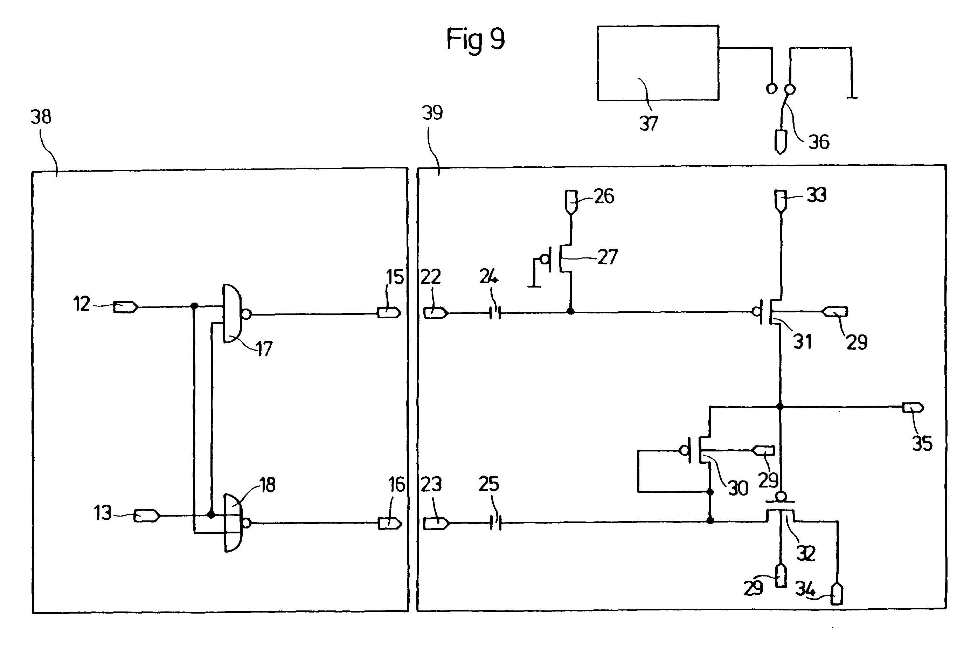

Das in Figur 9 dargestellte zweite Ausführungsbeispiel der erfindungsgemäßen Ansteuerschaltung 39 besitzt in wesentlichen einen ähnlichen Aufbau wie die Ansteuerschaltung 11 des ersten Ausführungsbeispiels. Die Selektionsschaltung 38 stellt hierbei eine um die Amplitudenverdopplerschaltung 19, 20, 21 und den zweiten externen Takteingang 14 reduzierte Version der Selektionsschaltung 10 dar. Die Selektionsschaltung 38 besteht aus dem Selektionseingang 12, dem ersten externen Takteingang 13, dem negierten UND-Gatter 17, dem negierten ODER-Gatter 18 und den internen Taktausgängen 15 und 16. Die Ansteuerschaltung 39 des zweiten Ausführungsbeispiels stellt ebenfalls eine reduzierte Version der entsprechenden Schaltung 11 nach dem ersten Ausführungsbeispiel dar. Es fehlt der als Deaktivierungsschalter arbeitende Transistor 28, und beim Transistor 32 ist gegenüber der Ansteuerschaltung 11 der Steuereingang mit der an die Ansteuerleitung 35 gekoppelten Elektrode vertauscht. Die Transistoren 30, 31 und 32 besitzen einen gemeinsamen, extern ansteuerbaren Substratanschluß 29.

Die Amplitudenverdopplerschaltung 19, 20, 21 ist für die Ansteuerschaltung 39 nicht erforderlich, da zur Ansteuerung des Transistores 32 eine beliebig kleiner Spannungspegel $U_{23, max}$ am zweiten internen Takteingang 23 ausreicht. Bei jeder Periode des am zweiten internen Takteingang 23 anliegenden Taktsignals $U_{23, max}$ verteilt sich die am Kondensator 25 gespeicherte Ladung gleichmäßig auf den Kondensator 25 und die als kapazitive Last $C_{SZ}$ wirkenden angesteuerten Speicherzellen SZ, wobei die am Kondensator 25 gespeicherte Ladung proportional zum Produkt aus der Amplitude $U_{23, max}$ des am zweiten internen Takteingang 23 anliegenden Taktsignals und der Kapazität $C_{25}$ des Kondensators 25 ist.

$$U_{32} = U_{35} \rightarrow U_{32} = U_{35} - (C_{25} * U_{23, max})/(C_{25} + C_{SZ})$$

Für die Ansteuerschaltung 39 reichen einerseits Taktsignale mit kleiner Amplitude $U_{23, max}$ am zweiten internen Takteingang 23 aus, andererseits fließt bei einem ungünstigen Kapazitätsverhältnis, bei welchem die Kapazität $C_{25}$ des Kondensators 25 klein gegenüber der Kapazität $C_{SZ}$ der angesteuerten Speicherzellen SZ ist, über die Ansteuerleitung 35 nur geringer Strom, was einen verhältnismäßig lange andauernden Pumpvorgang bedeutet. Dieser Nachteil läßt sich nur durch einen Kondensator 25 mit hoher Kapazität $C_{25}$ und einem damit verbundenen hohen Flächenbedarf auf dem Halbleitersubstrat 5 beheben.

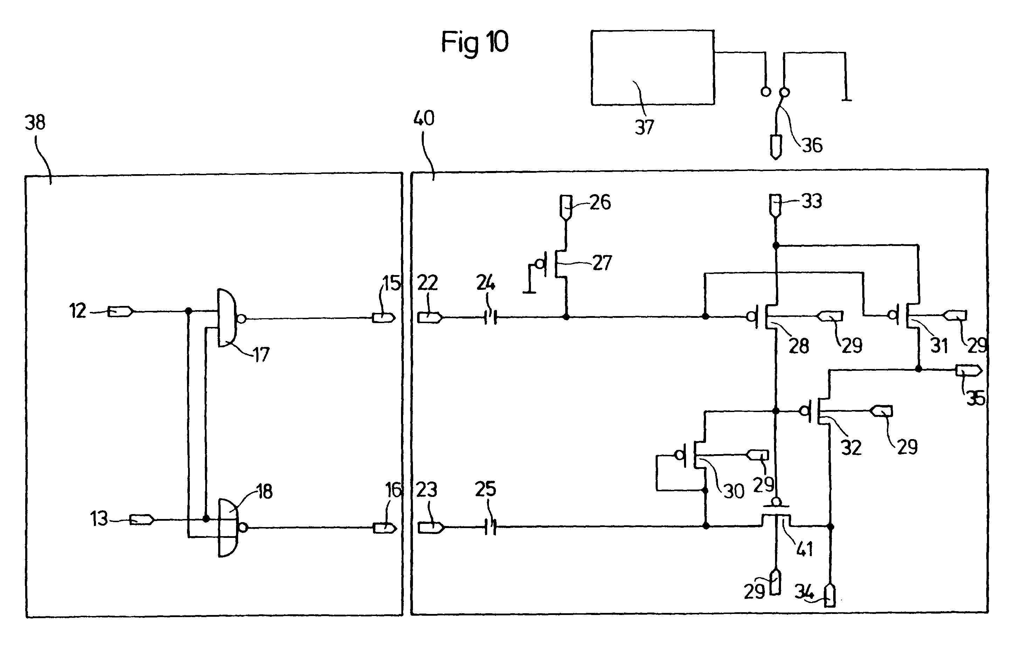

Das in der Figur 10 dargestellte dritte Ausführungsbeispiel besteht aus der Ansteuerschaltung 40 und aus der gleichen Selektionsschaltung 38 wie aus dem zweiten Ausführungsbeispiel. Die Ansteuerschaltung 40 ist eine Ausführung mit Elementen der Ansteuerschaltungen 11 und 39 aus den ersten beiden Ausführungsbeispielen. Gegenüber der Ansteuerschaltung 39 des zweiten Ausführungsbeispiels weist die Ansteuerschaltung 40 des dritten Ausführungsbeispiels einen weiteren Transistor 32 auf, welcher mit dem Transistor 41 in Reihe geschaltet ist und mit diesem einen gemeinsamen Steuereingang aufweist. Der Koppelpunkt der beiden hintereinandergeschalteten Transistoren 32 und 41 ist mit dem zweiten Spannungseingang 34 verbunden. Die dem Transistor 32 abgewandte Elektrode des Transistors 41 ist mit dem Kondensator 25 gekoppelt. Der als Rückkoppelglied arbeitende Transistor 30 ist abweichend von der Ansteuerschaltung 39 aus dem zweiten Ausführungsbeisiel zwischen dem gemeinsamen Steueranschluß der Transistoren 32 und 41 und dem Koppelpunkt des Transistors 41 mit dem Kondensator 25 geschaltet. Die Transistoren 28, 30, 31, 32 und 41 besitzen einen gemeinsamen, extern ansteuerbaren Substratanschluß 29.

Im ersten Betriebszustand arbeitet die Ansteuerschaltung 40 gegenüber den Ansteuerschaltungen 11, 39 wie folgt. Wie bei der Ansteuerschaltung 39 ist die Amplitudenverdopplerschaltung 19, 20, 21 auch für die Ansteuerschaltung 40 nicht erforderlich, um die zweite Pumpschaltung 25, 32, 41 zu aktivieren. Durch die beiden Transistoren 32 und 41 wird insbesondere im Vergleich zur Ansteuerschaltung 39 das Ausgangslastverhältnis verbessert. Bei jeder Periode des am zweiten internen Takteingang 23 anliegenden Taktsignals $U_{23}$ verteilt sich die am Kondensator 25 gespeicherte Ladung gleichmäßig auf den Kondensator 25 und die als kapazitive Last $C_{32, 41}$ wirkenden Steuereingänge der Transitoren 32 und 41, was für die an der Ansteuerleitung 35 anliegende Spannung U35 folgenden Übergang bewirkt:

$$U_{35} \rightarrow U_{35} - (C_{25} * U_{23, max})/(C_{25} + C_{32, 41}) \cong U_{35} - U_{23, max}$$

Aufgrund der verhältnismäßig kleinen Kapazität C32, 41 der gekoppelten Steuereingange der Transistoren 32 und 41 ist für den Kondensator 25 keine allzu große Kapazität $C_{25}$ und damit kein großer Flächenbedarf auf dem Halbleitersubstrat 5 erforderlich. Es läßt sich mit einem kleinen Kondensatoren 25 ein schneller Pumpvorgang erreichen. Im zweiten und dritten Betriebszustand arbeitet die Ansteuerschaltung 40 wie die Ansteuerschaltungen 13 und 39. Insgesamt stellt die Ansteuerschaltung 40 eine Synthese der Ansteuerschaltungen 13 und 39 dar.

**Patentansprüche**

1. Halbleiterspeichervorrichtung mit einer Vielzahl von auf einem Halbleitersubstrat (5) angeordneten Speicherzellen (SZ) zur programmierbaren Speicherung von Dateninhalten, welche Halbleiterspeichervorrichtung in wenigstens zwei Betriebszuständen betreibbar ist, von denen der erste einem Löschen des Dateninhalts aus einer Speicherzelle (SZ) und der zweite einer Aufrechterhaltung eines Dateninhalts einer Speicherzelle (SZ) zugeordnet ist, und welche eine Selektionssignalschaltung zur Auswahl einer zusammengehörenden Gruppe von Speicherzellen (SZ), sowie eine für alle Speicherzellen (SZ) einer Gruppe gemeinsam zugeordnete Ansteuerschaltung (11, 39, 40) mit einer einzigen Ansteuerleitung (35) zur Kopplung an sämtliche Speicherzellen (SZ) der ausgewählten Gruppe für die Betriebszustände Löschen und Aufrechterhalten des Dateninhalts der Speicherzellen (SZ) aufweist, wobei die Ansteuerschaltung (11, 39, 40) zur Selektion der auf der Ansteuerleitung (35) geschalteten Löschspannung und Referenzspannung durch ein in der der Ansteuerschaltung (11, 39, 40) vorgeschalteten Selektionssignalschaltung (10, 38) erzeugtes Selektionssignal gesteuert ist,
dadurch gekennzeichnet, daß
die Ansteuerschaltung (11, 39, 40) einen in Abhängigkeit des Selektionssignals wirkenden Pumpschaltkreis aufweist, welcher wahlweise die Lösch- und Referenzspannung aktiv an die ausgewählte Gruppe von Speicherzellen (SZ) schaltet.

2. Halbleiterspeichervorrichtung nach Anspruch 1, dadurch gekennzeichnet, daß die Halbleiterspeichervorrichtung in einem dritten Betriebszustand betreibbar ist, der wahlweise dem Programmieren, Lesen und Aufrechterhalten des Dateninhalts der Speicherzellen (SZ) zugeordnet ist, die Halbleiterspeichervorrichtung eine über eine Schalteinrichtung (36) mit der Ansteuerschaltung (11, 39, 40) gekoppelte Programmierspannungserzeugungsschaltung zur Versorgung der Ansteuerschaltung (11, 39, 40) mit einer gegenüber der Löschspannung entgegengesetztes Vorzeichen aufweisenden und den Wert der Versorgungsspannung übersteigenden Programmierspannung zum Programmieren einer Speicherzelle (SZ) aufweist, und die der Ansteuerschaltung (11, 39, 40) zugeordnete Schalteinrichtung (36) zur selektiven Ausgabe der an die Ansteuerschaltung (11, 39, 40) anzulegenden Programmierspannung, einer an die Ansteuerschaltung (11, 39, 40) anzulegenden Lesespannung, oder der an die Ansteuerschaltung (11, 39, 40) anzulegenden Referenzspannung vermittels einer Zustandsauswahlleitung an die ausgewählte Gruppe von Speicherzellen (SZ) gesteuert ist.

3. Halbleiterspeichervorrichtung nach Anspruch 2, dadurch gekennzeichnet, daß der Schalteinrichtung (36) eine der Programmierspannungserzeugungsschaltung nachgeschaltete Treiberschaltung (37) vorgeschaltet ist, die an die Schalteinrichtung (36) die dem dritten Betriebszustand zum Programmieren, Lesen und Aufrechterhalten des Dateninhalts der Speicherzellen (SZ) zugeordnete Spannungspegel ausgibt.

4. Halbleiterspeichervorrichtung nach Anspruch 2 oder 3, dadurch gekennzeichnet, daß die Ansteuerschaltung (11, 39, 40) einen mit der Schalteinrichtung (36) gekoppelten ersten Spannungseingang (33) aufweist, an welcher im ersten und zweiten Betriebszustand die Referenzspannung, und im dritten Betriebszustand die von der Treiberschaltung (37) ausgegebenen Spannungspegel anliegen.

5. Halbleiterspeichervorrichtung nach Anspruch 1 bis 4, dadurch gekennzeichnet, daß die Ansteuerschaltung (11, 39, 40) einen mit der Löschspannungserzeugungsschaltung gekoppelten zweiten Spannungseingang (34) aufweist, an welchem im ersten und zweiten Betriebszustand die Löschspannung und im dritten Betriebszustand die Löschspannung oder eine Spannung, welche betragsmäßig kleiner oder gleich der Programmierspannung ist, anliegt.

6. Halbleiterspeichervorrichtung nach Anspruch 1 bis 5, dadurch gekennzeichnet, daß die Ansteuerschaltung (11, 39, 40) eine über einen ersten internen Takteingang (22) zu aktivierende, zwischen dem ersten Spannungseingang (33) und der Ansteuerleitung (35) geschaltete erste Pumpschaltung (24, 31) aufweist, welche im ersten Betriebszustand zwischen dem ersten Spannungseingang (33) und der Ansteuerleitung (35) sperrt, im zweiten Betriebszustand als Pumpschaltung vom ersten Spannungseingang (33) zur Ansteuerleitung (35) arbeitet und im dritten Betriebszustand als Pumpschaltung zwischen der an den ersten Spannungseingang (33) gekoppelten Treiberschaltung (37) und der Ansteuerleitung (35) arbeitet.

7. Halbleiterspeichervorrichtung nach Anspruch 1 bis 6, dadurch gekennzeichnet, daß die Ansteuerschaltung (11, 39, 40) eine über einen zweiten internen Takteingang (23) zu aktivierende, zwischen dem zweiten Spannungseingang (34) und der Ansteuerleitung (35) geschaltete zweite Pumpschaltung (25, 32) aufweist, welche im ersten Betriebszustand als Pumpschaltung vom zweiten Spannungseingang (34) zur Ansteuerleitung (35) arbeitet und im zweiten und dritten Betriebszustand als Sperrschaltung zwischen dem zweiten Spannungseingang (34) und der Ansteuerleitung (35) arbeitet.

8. Halbleiterspeichervorrichtung nach Anspruch 1 bis 7, dadurch gekennzeichnet, daß die erste Pumpschaltung (24, 31) einen an einen extern ansteuerbaren Rücksetzeingang (26) gekoppelten Rücksetzschalter (27) aufweist.

9. Halbleiterspeichervorrichtung nach Anspruch 1 bis 8, dadurch gekennzeichnet, daß die zweite Pumpschaltung (25, 32) einen über den ersten internen Takteingang (22) ansteuerbaren Deaktivierungsschalter (28) aufweist.

10. Halbleiterspeichervorrichtung nach Anspruch 1 bis 9, dadurch gekennzeichnet, daß die Halbleiterspeichervorrichtung für wenigstens eine zusammengehörende Gruppe von Speicherzellen (SZ) einer Wortleitung (9) oder Bitleitung (8) der auf dem Halbleitersubstrat (5) an Kreuzungsstellen von matrixförmig in Wortleitungen (9) und Bitleitungen (8) angeordneten Speicherzellen (SZ) eine einzige Löschspannungserzeugungsschaltung und eine einzige Programmierspannungserzeugungsschaltung, die der wenigstens einen Ansteuerschaltung (11, 39, 40) zugeordnet sind, aufweist.

11. Halbleiterspeichervorrichtung nach Anspruch 1 bis 10, dadurch gekennzeichnet, daß die der Ansteuerschaltung (11, 39, 40) zugeordnete Selektionsschaltung (10, 38) in Abhängigkeit des am Selektionseingang (12) anliegenden Selektionssignals ein an einem externen Takteingang (13) anliegendes externes Taktsignal einem ersten oder einem zweiten internen Taktausgang (15 oder 16) zuordnet.

12. Halbleiterspeichervorrichtung nach Anspruch 1 bis 11, dadurch gekennzeichnet, daß die Selektionsschaltung (10, 38) bei einer logischen Null am Selektionseingang (12) das externe Taktsignal gegenphasig auf den ersten internen Taktausgang (15) legt und den zweiten internen Taktausgang (16) auf die logische Eins setzt und bei einer logischen Eins am Selektionseingang (12) das externe Taktsignal gegenphasig auf den zweiten internen Taktausgang (16) legt und den ersten internen Taktausgang (15) auf die logische Null setzt.

13. Halbleiterspeichervorrichtung nach Anspruch 1 bis 12, dadurch gekennzeichnet, daß im ersten und zweiten Betriebszustand der erste interne Taktausgang (15) der Selektionsschaltung (10, 38) mit dem ersten internen Takteingang (22) gekoppelt ist und der zweite interne Taktausgang (16) der Selektionsschaltung (10, 38) mit dem zweiten internen Takteingang (23) gekoppelt ist.

14. Halbleiterspeichervorrichtung nach Anspruch 1 bis 13, dadurch gekennzeichnet, daß die Schalter der ersten und zweiten Pumpschaltung (30, 31, 32, 41) und der der zweiten Pumpschaltung zugeordnete Deaktivierungsschalter (28) MOSFET-Transistoren mit einem gemeinsamen, extern ansteuerbaren Substratanschluß (29) aufweisen.

15. Halbleiterspeichervorrichtung nach Anspruch 14, dadurch gekennzeichnet, daß dem ersten internen Takteingang (22) ein erster Kondensator (24) und dem zweiten internen Takteingang (23) ein zweiter Kondensator (25) nachgeschaltet ist.

16. Halbleiterspeichervorrichtung nach Anspruch 1 bis 15, dadurch gekennzeichnet, daß die Treiberschaltung (37) wahlweise in Abhängigkeit von Treiberselektionseingängen (43, 44) anliegenden Treiberselektionssignalen die Spannung zum Programmieren, zum Lesen oder zur Aufrechterhaltung des Dateninhalts ausgibt.

17. Halbleiterspeichervorrichtung nach Anspruch 1 bis 16, dadurch gekennzeichnet, daß am gemeinsamen, extern ansteuerbaren Substratanschluß (29) im ersten und zweiten Betriebszustand die Referenzspannung, im dritten Betriebszustand und ersten Betriebsmodus die Programmierspannung und im dritten Betriebszustand und zweiten Betriebsmodus die Lesespannung anliegt.

18. Halbleiterspeichervorrichtung nach Anspruch 1 bis 17, dadurch gekennzeichnet, daß im dritten Betriebszustand am ersten internen Takteingang (22) unmittelbar nach dem Umschalten in den dritten Betriebszustand ein Taktsignal mit einer vorbestimmten zeitlichen Länge anliegt.

19. Halbleiterspeichervorrichtung nach Anspruch 1 bis 18, dadurch gekennzeichnet, daß die Selektionsschaltung (10) einen zweiten externen Takteingang (14) zum Anlegen eines, vom externen Taktsignal getrennten, zweiten externen Taktsignals und eine dem zweiten internen Taktausgang (16) und den beiden Takteingängen (13, 14) zugeordnete Amplitudenverdopplerschaltung (19 bis 21) aufweist, bei einer logischen Null am Selektionseingang (12) das externe Taktsignal gegenphasig auf den ersten internen Taktausgang (15) legt und den zweiten internen Taktausgang (16) auf die logische Eins setzt und bei einer logischen Eins am Selektionseingang (12) das externe Taktsignal gegenphasig, mit einer gegenüber dem externen Taktsignal erhöhten Amplitude, auf den zweiten internen Taktausgang (16) legt und den ersten internen Taktausgang (15) auf die logische Null setzt.

20. Halbleiterspeichervorrichtung nach Anspruch 1 bis 19, dadurch gekennzeichnet, daß die Referenzspannung eine Nullspannung darstellt, die Versorgungsspannung einen Wert von etwa + 5 Volt, die Löschspannung einen Wert von etwa - 12 Volt, und die Programmierspannung einen Wert von etwa + 18 Volt besitzt.

**EP 0 890 174 B1**

**Claims**

1. Semiconductor storage device with a multiplicity of storage cells (SZ), arranged on a semiconductor substrate (5), for programmable storage of data contents, which semiconductor storage device can be operated in at least two operating states, of which the first is assigned to erasing the data content from a storage cell (SZ) and the second is assigned to maintaining a data content of a storage cell (SZ), and which has a selection-signal circuit for selecting an associated group of storage cells (SZ), and a drive circuit (11, 39, 40), assigned in common for all storage cells (SZ) of a group and with a single drive line (35) for coupling to all storage cells (SZ) of the selected group, for the operating states of erasing and maintaining the data content of the storage cells (SZ), the drive circuit (11, 39, 40) having a pump circuit, acting as a function of the selection signal, which connects the erase and reference voltage actively to the selected group of storage cells (SZ) as desired.

2. Semiconductor storage device according to Claim 1, characterized in that the semiconductor storage device can be operated in a third operating state which, as desired, is assigned to programming, reading and maintaining the data content of the storage cells (SZ), the semiconductor storage device having a programming-voltage generation circuit, coupled via a switching device (36) to the drive circuit (11, 39, 40), for supplying the drive circuit (11, 39, 40) with a programming voltage, having an opposite sign to the erase voltage and exceeding the value of the supply voltage, for programming a storage cell (SZ), and the switching device (36), assigned to the drive circuit (11, 39, 40), for selective output of the programming voltage to be applied to the drive circuit (11, 39, 40), of a read voltage to be applied to the drive circuit (11, 39, 40), or of the reference voltage to be applied to the drive circuit (11, 39, 40) being controlled by means of a state selection line to the selected group of storage cells (SZ).

3. Semiconductor storage device according to Claim 2, characterized in that a driver circuit (37), connected downstream of the programming-voltage generation circuit, is connected upstream of the switching device (36) and outputs to the switching device (36) the voltage levels assigned to the third operating state for programming, reading and maintaining the data content of the storage cells (SZ).

4. Semiconductor storage device according to Claim 2 or 3, characterized in that the drive circuit (11, 39, 40) has a first voltage input (33), coupled to the switching device (36), to which the reference voltage is applied in the first and second operating states, and the voltage levels output by the driver circuit (37) are applied in the third operating state.

5. Semiconductor storage device according to one of Claims 1 to 4, characterized in that the drive circuit (11, 39, 40) has a second voltage input (34), coupled to the erase-voltage generation circuit, to which the erase voltage is applied in the first and second operating states and the erase voltage, or a voltage which is less than or equal to the programming voltage in terms of magnitude, is applied in the third operating state.

6. Semiconductor storage device according to one of Claims 1 to 5, characterized in that the drive circuit (11, 39, 40) has a first pump circuit (24, 31), to be activated via a first internal clock input (22) and connected between the first voltage input (33) and the drive line (35), which blocks between the first voltage input (33) and the drive line (35) in the first operating state, operates as a pump circuit from the first voltage input (33) to the drive line (35) in the second operating state, and operates as a pump circuit between the driver circuit (37), coupled to the first voltage input (33), and the drive line (35) in the third operating state.

7. Semiconductor storage device according to one of Claims 1 to 6, characterized in that the drive circuit (11, 39, 40) has a second pump circuit (25, 32), to be activated via a second internal clock input (23) and connected between the second voltage input (34) and the drive line (35), which operates as a pump circuit from the second voltage input (34) to the drive line (35) in the first operating state, and operates as a blocking circuit between the second voltage input (34) and the drive line (35) in the second and third operating states.

8. Semiconductor storage device according to one of Claims 1 to 7, characterized in that the first pump circuit (24, 31) has a reset switch (27) coupled to an externally drivable reset input (26).

9. Semiconductor storage device according to one of Claims 1 to 8, characterized in that the second pump circuit (25, 32) has a deactivation switch (28) which can be driven via the first internal clock input (22).

10. Semiconductor storage device according to one of Claims 1 to 9, characterized in that the semiconductor storage device for at least one associated group of storage cells (SZ) of a word line (9) or bit line (8) of the storage cells

13

(SZ) arranged on the semiconductor substrate (5) at intersections of word lines (9) and bit lines (8) in matrix form has a single erase-voltage generation circuit and a single programming-voltage generation circuit, which are assigned to the at least one drive circuit (11, 39, 40).

11. Semiconductor storage device according to one of Claims 1 to 10, characterized in that the selection circuit (10, 38) assigned to the drive circuit (11, 39, 40), as a function of the selection signal applied to the selection input (12), assigns an external clock signal, applied to an external clock input (13), to a first or to a second internal clock output (15 or 16).

12. Semiconductor storage device according to one of Claims 1 to 11, characterized in that, for a logical zero at the selection input (12), the selection circuit (10, 38) applies the external clock signal in phase opposition to the first internal clock output (15) and sets the second internal clock output (16) to logical one, and, for a logical one at the selection input (12), applies the external clock signal in phase opposition to the second internal clock output (16) and sets the first internal clock output (15) to logical zero.

13. Semiconductor storage device according to one of Claims 1 to 12, characterized in that, in the first and second operating states, the first internal clock output (15) of the selection circuit (10, 38) is coupled to the first internal clock input (22), and the second internal clock output (16) of the selection circuit (10, 38) is coupled to the second internal clock input (23).

14. Semiconductor storage device according to one of Claims 1 to 13, characterized in that the switches of the first and second pump circuits (30, 31, 32, 41), and the deactivation switch (28) assigned to the second pump circuit have MOSFET transistors with a common externally drivable substrate terminal (29).

15. Semiconductor storage device according to Claim 14, characterized in that a first capacitor (24) is connected downstream of the first internal clock input (22), and a second capacitor (25) is connected downstream of the second internal clock input (23).

16. Semiconductor storage device according to one of Claims 1 to 15, characterized in that, as a function of driver-selection signals applied to driver-selection inputs (43, 44), the driver circuit (37) outputs the voltage for programming, for reading or for maintaining the data content, as desired.

17. Semiconductor storage device according to one of Claims 1 to 16, characterized in that the reference voltage is applied to the common externally drivable substrate terminal (29) in the first and second operating states, the programming voltage is applied in the third operating state and first operating mode, and the read voltage is applied in the third operating state and second operating mode.

18. Semiconductor storage device according to one of Claims 1 to 17, characterized in that a clock signal with a predetermined time length is applied in the third operating state to the first internal clock input (22), directly after switching to the third operating state.

19. Semiconductor storage device according to one of Claims 1 to 18, characterized in that the selection circuit (10) has a second external clock input (14) for applying a second external clock signal, separate from the external clock signal, and an amplitude-doubler circuit (19 to 21) assigned to the second internal clock output (16) and to the two clock inputs (13, 14), for a logical zero at the selection input (12), applies the external clock signal in phase opposition to the first internal clock output (15) and sets the second internal clock output (16) to logical one, and, for a logical one at the selection input (12), applies the external clock signal in phase opposition, with an amplitude which is increased compared to the external clock signal, to the second internal clock output (16) and sets the first internal clock output (15) to logical zero.

20. Semiconductor storage device according to one of Claims 1 to 19, characterized in that the reference voltage represents a zero voltage, the supply voltage has a value of about + 5 volts, the erase voltage has a value of about - 12 volts, and the programming voltage has a value of about + 18 volts.

**Revendications**

1. Dispositif de mémoire à semi-conducteurs avec une pluralité de cellules de mémoire (SZ) disposées sur un substrat

**EP 0 890 174 B1**

semi-conducteur (5) pour le stockage programmable de contenus de données, lequel dispositif de mémoire à semi-conducteurs peut être utilisé dans au moins deux états de fonctionnement, dont le premier est attribué à un effacement du contenu de données d'une cellule de mémoire (SZ) et le deuxième à une conservation d'un contenu de données d'une cellule de mémoire (SZ), et lequel comporte un circuit de signaux de sélection pour la sélection d'un groupe cohérent de cellules de mémoire (SZ), ainsi qu'un circuit de commande (11, 39, 40) commun à toutes les cellules de mémoire (SZ) d'un groupe avec une seule ligne de commande (35) à coupler à l'ensemble des cellules de mémoire (SZ) du groupe sélectionné pour les états effacement et conservation du contenu de données des cellules de mémoire (SZ), le circuit de commande (11, 39, 40) pour la sélection de la tension d'effacement et de la tension de référence appliquées à la ligne de commande (35) étant commandé par un signal de sélection généré dans le circuit de signaux de sélection (10, 38) monté en amont du circuit de commande (11, 39, 40), caractérisé en ce que le circuit de commande (11, 39, 40) comporte un circuit de pompage agissant en fonction du signal de sélection, lequel applique activement, au choix, la tension d'effacement et de référence au groupe sélectionné de cellules de mémoire (SZ).

2. Dispositif de mémoire à semi-conducteurs selon la revendication 1, caractérisé en ce que le dispositif de mémoire à semi-conducteurs peut être utilisé dans un troisième état de fonctionnement attribué, au choix, à la programmation, à la lecture et à la conservation du contenu de données des cellules de mémoire (SZ), en ce que le dispositif de mémoire à semi-conducteurs comporte un circuit générateur de tension de programmation couplé au circuit de commande (11, 39, 40) via un dispositif de commutation (36) et destiné à alimenter le circuit de commande (11, 39, 40) avec une tension de programmation de signe opposé à la tension d'effacement et dépassant la valeur de la tension d'alimentation pour la programmation d'une cellule de mémoire (SZ) et en ce que le dispositif de commutation (36) attribué au circuit de commande (11, 39, 40), pour la sortie sélective de la tension de programmation à appliquer au circuit de commande (11, 39, 40), d'une tension de lecture à appliquer au circuit de commande (11, 39, 40) ou de la tension de référence à appliquer au circuit de commande (11, 39, 40) est amené au groupe sélectionné de cellules de mémoire (SZ) au moyen d'une ligne de sélection d'état.

3. Dispositif de mémoire à semi-conducteurs selon la revendication 2, caractérisé en ce que le dispositif de commutation (36) est précédé d'un circuit d'attaque (37) monté en aval du circuit générateur de tension de programmation, qui fournit au dispositif de commutation (36) les niveaux de tension attribués au troisième état de fonctionnement pour la programmation, la lecture et la conservation du contenu de données des cellules de mémoire (SZ).

4. Dispositif de mémoire à semi-conducteurs selon la revendication 2 ou 3, caractérisé en ce que le circuit de commande (11, 39, 40) comporte une première entrée de tension (33) couplée au dispositif de commutation (36), qui se voit appliquer dans le premier et deuxième état de fonctionnement la tension de référence et dans le troisième état de fonctionnement les niveaux de tension fournis par le circuit d'attaque (37).

5. Dispositif de mémoire à semi-conducteurs selon les revendications 1 à 4, caractérisé en ce que le circuit de commande (11, 39, 40) comporte une deuxième entrée de tension (34) couplée au circuit générateur de tension d'effacement, qui se voit appliquer dans le premier et deuxième état de fonctionnement la tension d'effacement et dans le troisième état de fonctionnement la tension d'effacement ou une tension dont la valeur est inférieure ou égale à la tension de programmation.

6. Dispositif de mémoire à semi-conducteurs selon les revendications 1 à 5, caractérisé en ce que le circuit de commande (11, 39, 40) comporte un premier circuit de pompage (24, 31) à activer par une première entrée de signaux d'horloge interne (22) et monté entre la première entrée de tension (33) et la ligne de commande (35), lequel bloque entre la première entrée de tension (33) et la ligne de commande (35) dans le premier état de fonctionnement et agit comme circuit de pompage de la première entrée de tension (33) à la ligne de commande (35) dans le deuxième état de fonctionnement et comme circuit de pompage entre le circuit d'attaque (37) couplé à la première entrée de tension (33) et la ligne de commande (35) dans le troisième état de fonctionnement.

7. Dispositif de mémoire à semi-conducteurs selon les revendications 1 à 6, caractérisé en ce que le circuit de commande (11, 39, 40) comporte un deuxième circuit de pompage (25, 32) à activer par une deuxième entrée de signaux d'horloge interne (23) et monté entre la deuxième entrée de tension (34) et la ligne de commande (35), lequel agit comme circuit de pompage de la deuxième entrée de tension (34) à la ligne de commande (35) dans le premier état de fonctionnement et comme circuit de blocage entre la deuxième entrée de tension (34) et la ligne de commande (35) dans le deuxième et troisième état de fonctionnement.

8. Dispositif de mémoire à semi-conducteurs selon les revendications 1 à 7, caractérisé en ce que le premier circuit

**15**

de pompage (24, 31) comporte un actionneur de réinitialisation (27) couplé à une entrée de réinitialisation (26) à commande externe.

9. Dispositif de mémoire à semi-conducteurs selon les revendications 1 à 8, caractérisé en ce que le deuxième circuit de pompage (25, 32) comporte un commutateur de désactivation (28) pouvant être commandé par la première entrée de signaux d'horloge interne (22).

10. Dispositif de mémoire à semi-conducteurs selon les revendications 1 à 9, caractérisé en ce que le dispositif de mémoire à semi-conducteurs comporte pour au moins un groupe cohérent de cellules de mémoire (SZ) d'une ligne de mot (9) ou d'une ligne de bit (8) des cellules de mémoire (SZ) placées sur le substrat semi-conducteur (5) aux points d'intersection de lignes de mot (9) ou de lignes de bit (8) disposées en forme de matrice, un seul circuit générateur de tension d'effacement et un seul circuit générateur de tension de programmation qui sont attribués au au moins un circuit de commande (11, 39, 40).

11. Dispositif de mémoire à semi-conducteurs selon les revendications 1 à 10, caractérisé en ce que le circuit de sélection (10, 38) attribué au circuit de commande (11, 39, 40) attribue en fonction du signal de sélection appliqué à l'entrée de sélection (12), un signal d'horloge externe appliqué à une entrée de signaux d'horloge externe (13) à une première ou une deuxième sortie de signaux d'horloge interne (15 ou 16).

12. Dispositif de mémoire à semi-conducteurs selon les revendications 1 à 11, caractérisé en ce qu'en cas d'un "0" logique à l'entrée de sélection (12), le circuit de sélection (10, 38) applique le signal d'horloge externe en opposition de phase à la première sortie de signaux d'horloge interne (15), la deuxième sortie de signaux d'horloge interne (16) étant mise au "1" logique, et en ce qu'en cas d'un "1" logique à l'entrée de sélection (12), il applique le signal d'horloge externe en opposition de phase à la deuxième sortie de signaux d'horloge interne (16), la première sortie de signaux d'horloge interne (15) étant mise au "0" logique.

13. Dispositif de mémoire à semi-conducteurs selon les revendications 1 à 12, caractérisé en ce que dans le premier et deuxième état de fonctionnement, la première sortie de signaux d'horloge interne (15) du circuit de sélection (10, 38) est couplée à la première entrée de signaux d'horloge interne (22), la deuxième sortie de signaux d'horloge interne (16) du circuit de sélection (10, 38) étant couplée à la deuxième entrée de signaux d'horloge interne (23).

14. Dispositif de mémoire à semi-conducteurs selon les revendications 1 à 13, caractérisé en ce que les commutateurs du premier et deuxième circuit de pompage (30, 31, 32, 41) et le commutateur de désactivation (28) attribué au deuxième circuit de pompage comportent des transistors MOSFET dotés d'une connexion au substrat (29) commune à commande externe.

15. Dispositif de mémoire à semi-conducteurs selon la revendication 14, caractérisé en ce qu'un premier condensateur (24) est monté en aval de la première entrée de signaux d'horloge interne (22) et un deuxième condensateur (25) en aval de la deuxième entrée de signaux d'horloge interne (23).

16. Dispositif de mémoire à semi-conducteurs selon les revendications 1 à 15, caractérisé en ce que le circuit d'attaque (37) fournit au choix, en fonction des signaux de sélection d'attaque appliqués aux entrées de sélection d'attaque (43, 44), la tension pour la programmation, la lecture ou la conservation du contenu de données.

17. Dispositif de mémoire à semi-conducteurs selon les revendications 1 à 16, caractérisé en ce que la connexion au substrat (29) commune à commande externe se voit appliquer dans le premier et deuxième état de fonctionnement la tension de référence, dans le troisième état de fonctionnement et le premier mode de fonctionnement la tension de programmation et dans le troisième état de fonctionnement et le deuxième mode de fonctionnement la tension de lecture.

18. Dispositif de mémoire à semi-conducteurs selon les revendications 1 à 17, caractérisé en ce que dans le troisième état de fonctionnement, aussitôt après la commutation audit troisième état de fonctionnement, la première entrée de signaux d'horloge (22) interne se voit appliquer un signal d'horloge de longueur prédéfinie.

19. Dispositif de mémoire à semi-conducteurs selon les revendications 1 à 18, caractérisé en ce que le circuit de sélection (10) comporte une deuxième entrée de signaux d'horloge externe (14) pour l'application d'un deuxième signal d'horloge externe séparé du signal d'horloge externe, ainsi qu'un circuit doubleur d'amplitude (19 à 21) attribué à la deuxième sortie de signaux d'horloge externe (16) et aux deux entrées de signaux d'horloge (13, 14), en ce qu'en cas d'un "0" logique à l'entrée de sélection (12), il applique le signal d'horloge externe en opposition de phase à la première sortie de signaux d'horloge interne (15), la deuxième sortie de signaux d'horloge interne (16) étant mise au "1" logique, et en ce qu'en cas d'un "1" logique à l'entrée de sélection (12), il applique le signal d'horloge externe, en opposition de phase et avec une amplitude augmentée par rapport au signal d'horloge externe, à la deuxième sortie de signaux d'horloge interne (16), la première sortie de signaux d'horloge interne (15) étant mise au "0" logique.

20. Dispositif de mémoire à semi-conducteurs selon les revendications 1 à 19, caractérisé en ce que la tension de référence représente une tension nulle, la tension d'alimentation possédant une valeur d'environ + 5 volt, la tension d'effacement une valeur d'environ - 12 volt et la tension de programmation une valeur d'environ + 18 volt.

Fig 1a

SZ    1    6    7    2    3    5    4

Fig 1b

SZ    1    2    3    4    5

Fig 2

8    8    8    8    SZ    SZ    SZ    9    9    9    9

Fig 3

EP 0 890 174 B1

Fig 4

Fig 5

EP 0 890 174 B1

Fig 6

Fig 7

EP 0 890 174 B1

Fig 8

Fig 9

EP 0 890 174 B1

Fig 10